(19) Europäisches Patentamt
European Patent Office
Office européen des brevets

(11) **EP 4 550 450 A1**

(12) **EUROPEAN PATENT APPLICATION**
published in accordance with Art. 153(4) EPC

(43) Date of publication:
07.05.2025  Bulletin 2025/19

(21) Application number: 22956160.0

(22) Date of filing: 26.08.2022

(51) International Patent Classification (IPC):
$H01M\ 4/134$ (2010.01)   $H01M\ 4/133$ (2010.01)

(52) Cooperative Patent Classification (CPC):
H01M 4/0471; H01M 4/0428; H01M 4/133;
H01M 4/134; H01M 4/1395; H01M 4/36;
H01M 4/362; H01M 4/364; H01M 4/386;
H01M 4/583; H01M 4/587; H01M 4/625;
H01M 10/052; H01M 10/0525; H01M 2004/021;
(Cont.)

(86) International application number:
PCT/CN2022/115303

(87) International publication number:
WO 2024/040615 (29.02.2024 Gazette 2024/09)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: CONTEMPORARY AMPEREX
TECHNOLOGY
(HONG KONG) LIMITED
Central (HK)

(72) Inventors:
• WU, Kai
  Ningde, Fujian 352100 (CN)

• LI, Yuan
  Ningde, Fujian 352100 (CN)
• DONG, Xiaobin
  Ningde, Fujian 352100 (CN)
• WANG, Jiazheng
  Ningde, Fujian 352100 (CN)
• LIU, Liangbin
  Ningde, Fujian 352100 (CN)
• LV, Zijian
  Ningde, Fujian 352100 (CN)
• QIN, Yuwei
  Ningde, Fujian 352100 (CN)

(74) Representative: Gong, Jinping
CocreateIP
Neumarkterstr. 21
81673 München (DE)

(54) **SILICON-CARBON COMPOSITE MATERIAL AND PREPARATION METHOD THEREFOR, AND SECONDARY BATTERY COMPRISING SAME**

(57)    The present application provides a silicon-carbon composite material and a preparation method thereof, a negative electrode plate, and a secondary battery. The silicon-carbon composite material includes a porous carbon matrix and silicon-based particles. The porous carbon matrix internally includes a plurality of pore channels with a width of 5 nm-50 nm. The silicon-based particles are distributed in the pore channels, and the porous carbon matrix meets: $1.0\times10^{-7}\leq V_{total}/S_{total}\leq10.0\times10^{-7}$, where $S_{total}$ is the total surface area occupied by the pore channels with the width of 5 nm-50 nm, and the measurement unit is: $\times10^4\ cm^2/g$; and $V_{total}$ is the total pore volume occupied by the pore channels with the width of 5 nm-50 nm, and the measurement unit is: $cm^3/g$. The silicon-carbon composite material has high electrical conductivity and structural stability. When being applied to a negative electrode of the secondary battery, the silicon-carbon composite material can effectively increase the volume capacity and energy density of the secondary battery, and makes the secondary battery have a good cycle life.

FIG. 3

(52) Cooperative Patent Classification (CPC): (Cont.)
H01M 2004/027; Y02E 60/10

**Description**

**TECHNICAL FIELD**

The present application relates to the technical field of batteries, and in particular to a silicon-carbon composite material and a preparation method thereof, and a secondary battery including the silicon-carbon composite material.

**BACKGROUND**

In recent years, secondary batteries are widely applied to various electronic products and electric vehicles due to their high power density and volume specific capacity. However, with the great development and wide application of the secondary batteries, higher requirements are put forward for the volume capacity, energy density and cycle life.
Graphite is usually used as a negative electrode material in the second batteries, but the theoretical capacity of the graphite is low (372mA·h/g), which cannot meet the demand for the secondary batteries with higher volume capacity and energy density. A silicon-base material has become a more ideal negative electrode material of the secondary batteries due to its extremely high theoretical capacity (4200 mAh/g) and low lithium insertion potential. However, the extremely low electrical conductivity and large volume expansion of the silicon material limit the application of the silicon material. Therefore, how to improve the electrochemical performance of the secondary batteries which take the silicon-based material as the negative electrode material has become an urgent technical problem.

**SUMMARY**

In view of the above technical problem, an objective of the present application is to provide a silicon-carbon composite material. The composite material has high electrical conductivity and structural stability, so that the composite material can improve the energy density of a secondary battery and also can make the secondary battery have a good cycle life.
According to a first aspect, the present application provides a silicon-carbon composite material. The silicon-carbon composite material includes a porous carbon matrix and silicon-based particles. The porous carbon matrix internally includes a plurality of pore channels with a width of 5 nm-50 nm. The silicon-based particles are distributed in the pore channels, and the porous carbon matrix meets: $1.0 \times 10^{-7} \leq V_{total}/S_{total} \leq 10 \times 10^{-7}$, where $S_{total}$ is the total surface area occupied by the pore channels with the width of 5 nm-50 nm, and the measurement unit is: $\times 10^4$ cm$^2$/g; and $V_{total}$ is the total pore volume occupied by the pore channels with the width of 5 nm-50 nm, and the measurement unit is: cm$^3$/g.
The silicon-carbon composite material provided by the present application has a porous carbon matrix. The porous carbon matrix has a plurality of long and narrow pore channels, so that the porous carbon matrix forms a crosslinked three-dimensional net structure, and the silicon-based particles are distributed in the mutually crosslinked pore channels. On one hand, the three-dimensional net structure of the porous carbon matrix can accommodate and limit the expansion of the silicon-based particles and improve the damage to the structure of the composite material caused by the expansion of the silicon-based particles in the battery cycle process, so as to improve the cycle stability of the composite material in the battery; and on the other hand, the specific pore distribution and structure of the porous carbon matrix are favorable for silicon to occupy pores in a carbon skeleton and be dispersed inside the carbon material, and efficient electron transmission can be realized through the crosslinked carbon skeleton with high electrical conductivity, so that the silicon-carbon composite material has high specific capacity and high electrical conductivity, and is conducive to reducing the polarization of the battery when being applied to the battery.
In some embodiments, $1.0 \leq V_{total}/S_{total} \leq 10$, optionally, $2.0 \leq V_{total}/S_{total} \leq 5.0$, and the unit is: $10^{-7}$ cm.
In some embodiments, $10 \leq S_{total} \leq 50$, optionally, $1 \leq S_{total} \leq 30$, and the unit is: $\times 10^4$ cm$^2$/g.
In some embodiments, $0.002 \leq V_{total} \leq 0.250$, optionally, $0.004 \leq V_{total} \leq 0.200$, and the unit is: cm$^3$/g.
In the embodiments of the present application, the porous carbon matrix has long and narrow pore channels with a width of 5 nm-50 nm, the porous carbon matrix meeting the above condition forms a three-dimensional crosslinked net structure, and at least two pore channels communicating with each other are present in the structure, so that the porous carbon matrix has the three-dimensional net structure and also has large specific surface area, and has enough position and volume for the silicon-based particles to be distributed thereon. The pore channel structure in the porous carbon matrix has large volume and can accommodate and limit the expansion of the silicon-based particles in the battery cycle process, thereby maintaining the structural stability of the silicon-carbon material in the battery cycle process.
In some embodiments, the powder resistivity of the porous carbon matrix under the pressure of 4 MPa is 1 Ω/cm-300 Ω/cm, optionally, 1 Ω/cm-100 Ω/cm.
The silicon-carbon composite material provided by the embodiments of the present application has a porous carbon matrix with extremely low powder resistivity, and a carbon skeleton with high electrical conductivity is constructed through the porous carbon matrix, so that the silicon-carbon composite material obtained by compounding the carbon skeleton and the silicon-based particles also has high electrical conductivity.

In some embodiments, the grain size of the silicon-based particles is less than or equal to 20 nm, preferably, 2 nm-10 nm.

In some embodiments, the volume particle size distribution of the porous carbon matrix is: $D_{v50} \leq 10 \ \mu m$, optionally, $5 \leq D_{v50} \leq 10 \ \mu m$; and/or the volume particle size distribution of the porous carbon matrix is: $D_{v90} \leq 20 \ \mu m$, optionally, $10 \leq D_{v90} \leq 15 \mu m$.

In some embodiments, the content of the silicon-based particles in the silicon-carbon composite material is 25%-65%, optionally, 35%-45%.

In the embodiments of the present application, by controlling the content of the silicon-based particles in the silicon-carbon composite material within a suitable range, the problems of excessively low silicon content and low specific capacity of the silicon-carbon composite material can be effectively avoided, or the problems of excessively high silicon content and damage to the excellent electric conductivity of the carbon skeleton caused by excessive silicon-based particles can be avoided. Therefore, it is conducive to increase the specific capacity of the silicon-carbon composite material and improve the cycle stability of the silicon-carbon material in the battery.

In some embodiments, the powder resistivity R of the silicon-carbon composite material under the pressure of 12 MPa is less than or equal to 300 $\Omega$/cm, optionally, 1.1 $\Omega$/cm-200 $\Omega$/cm; and/or the powder resistivity R of the silicon-carbon composite material under the pressure of 16 MPa is less than or equal to 200 $\Omega$/cm, optionally, 1 $\Omega$/cm-100 $\Omega$/cm.

In the embodiments of the present application, due to the mutually crosslinked three-dimensional net structure of the porous carbon matrix, the silicon-based particles are uniformly distributed inside the matrix, and the silicon-carbon composite material has low powder resistivity, in other words, good electrical conductivity, so that the silicon-carbon composite material has high specific capacity in the battery, and also has good structural stability and cycle stability.

In some embodiments, the silicon-carbon composite material meets one or more of the following (1) to (6): (1) the volume particle size distribution of the silicon-carbon composite material is Dv10≤5μm, optionally, 3≤Dv10≤5 μm; (2) the volume particle size distribution of the silicon-carbon composite material is Dv50≤10 μm, optionally, 5≤Dv10≤8 μm; (3) the volume particle size distribution of the silicon-carbon composite material is 10≤Dv90≤20 μm, optionally, 10≤Dv90≤15 μm; (4) the volume particle size distribution of the silicon-carbon composite material is (Dv90-Dv10)/Dv50≤1.8, optionally, 1.4≤(Dv90-Dv10)/Dv50≤1.6; (5) the compaction density of the silicon-carbon composite material under the pressure of 2 MPa is 1 g/cm³-1.5 g/cm³, optionally, 1.1 g/cm³-1.3 g/cm³; and (6) the specific surface area of the silicon-carbon composite material is 2 m²/g -10 m²/g, optionally, 3 m²/g - 7 m²/g.

In some embodiments, the peak value of an X-ray diffraction (XRD) peak of the carbon-based composite material between the diffraction angle 28° and 29° is denoted as P1, and the peak value of an XRD peak of the silicon-based particles between the diffraction angle 42° and 45° is denoted as P2, then 2≤P1/P2≤4, optionally, 600≤P1≤800, and optionally, 200≤P2≤400.

According to a second aspect, a preparation method of a silicon-carbon composite material is provided. The preparation method includes: mixing a base material and a pore-forming agent in a solvent to obtain a first mixture; treating the first mixture at a high temperature to obtain a porous carbon matrix; and depositing a silane gas in the porous carbon matrix through chemical vapor deposition to obtain the silicon-carbon composite material.

In some embodiments, the base material includes at least one of sugar and resin; optionally, the sugar includes at least one of glucose, sucrose, fructose, starch, amylopectin, amylose, lignin, dextrin and maltodextrin; and optionally, the resin includes at least one of linear phenolic resin, soluble phenolic resin, epoxy resin and polyurethane.

In some embodiments, the pore-forming agent includes at least one of sodium chloride, potassium chloride, zinc chloride, sodium carbonate and potassium carbonate.

In some embodiments, a mass ratio of the base material to the pore-forming agent is 1:5-10:1, optionally, 2:1-5:1.

In the embodiments of the present application, the use amount of the pore-forming agent is determined according to the amount of the base material, so that the situation that sufficient gas cannot be generated to form a pore channel structure of 2 nm-10 nm due to the insufficient use amount of the pore-forming agent can be avoided, or the situation that local reaction is violent to rapidly generate gas due to the excessive use amount of the pore-forming agent to cause large pores can be avoided. Therefore, it can be ensured that the prepared porous carbon matrix has a three-dimensional net structure formed by mutually crosslinked pore channels of 5 nm-50 nm by controlling the mass ratio of the base material to the pore-forming agent within a suitable range.

In some embodiments, the solvent includes water or alcohol, where the alcohol includes at least one of methanol, ethanol, ethylene glycol, polyethylene glycol, glycerol, isopropanol or polyalcohol.

In some embodiments, the mass ratio of the base material to the solvent is 1:100-10:1, optionally, 1:2-10:1.

In the embodiments of the present application, the use amount of the solvent is determined according to the amount of the base material, the situation that after the pore-forming agent generates gas, the gas cannot be dispersed timely due to excessively few solvents and excessively high viscosity of the first mixture to cause the pore size larger or longer can be avoided, or the situation that after the pore-forming agent generates gas, the gas is discharged rapidly due to excessive use amount of the solvent and excessively low viscosity of the first mixture to cause the pore-forming failure can be avoided. Therefore, the quality of the pore channels in the prepared porous carbon matrix can be further ensured by controlling the mass ratio of the base material to the solvent within a suitable range.

In some embodiments, the mixing a base material and a pore-forming agent in a solvent includes: mixing the base material and the pore-forming agent in the solvent through stirring, where optionally, the stirring speed is 100 rpm/min-1500 rpm/min, further optionally, 200 rpm/min-1000 rpm/min.

In some embodiments, the treating the first mixture at a high temperature to obtain a porous carbon matrix includes: treating the first mixture at a first temperature to obtain a second mixture, where the second mixture is a solid mixture; treating the second mixture at a second temperature to obtain a carbon precursor; and treating the carbon precursor at a third temperature to obtain the porous carbon matrix.

In the embodiments of the present application, firstly, the first mixture is treated at the first temperature, and in this process, the excess solvent is volatilized and the base material is preliminarily solidified into the second mixture; then, the second mixture is treated at the second temperature, and in this process, the first mixture is further solidified to form the carbon precursor; and subsequently, the carbon precursor is treated at the third temperature, and in this process, the pore-forming agent in the carbon precursor and the residual solvent are pyrolyzed to generate gas at high temperature so as to form pores in the base material. Therefore, through the multi-temperature and multi-step heating processes, the first mixture can be converted into the porous carbon matrix with the mutually crosslinked pore channel structures inside. Through the multi-temperature and multi-step heating, the distribution uniformity of the pore-forming agent in the carbon precursor can be effectively improved, so that the pore channels in the finally prepared porous carbon matrix are uniformly distributed in the material.

In some embodiments, the first temperature, the second temperature and the third temperature meet one or more of the following (I) to (III): (I) the first temperature is 40°C-80°C, optionally, 40°C -60°C; (II) the second temperature is 100°C-200°C, optionally, 150°C-180°C; and (III) the third temperature is 600°C-1200°C, optionally, 800°C-1000°C.

In the embodiments of the present application, by controlling the first temperature within a suitable range, the situation that the first temperature is excessively high, a large number of aggregated micropores appear locally and the finally obtained pore channels are excessively long or oversized pore channels appear can be avoided, or the situation that the first temperature is excessively low, which is not conducive to the solidification of the first mixture and affects the subsequent processing can be avoided.

In some embodiments, the preparation method includes: crushing the second mixture before treating the second mixture at the second temperature.

In some embodiments, the preparation method further includes: crushing the carbon precursor before treating the carbon precursor at the third temperature, where optionally, after the carbon precursor is crushed, the particle size of the carbon precursor is 1 $\mu$m-1000 $\mu$m, further optionally, 5 $\mu$m-100 $\mu$m.

In some embodiments, the treating the carbon precursor at a third temperature includes: treating the carbon precursor in an inert gas at the third temperature, where optionally, the inert gas includes at least one of nitrogen, argon and helium.

In some embodiments, the preparation method further includes: performing impurity removal and/or demagnetization on the porous carbon matrix before depositing the silicon-based particles in the porous carbon matrix.

In some embodiments, the atmosphere of the chemical vapor deposition is a mixed gas of a silane gas and hydrogen, where optionally, the volume of the silane gas accounts for 10%-50% of the volume of the mixed gas.

In some embodiments, the flow of depositing the silane gas through the chemical vapor deposition is 0.5 L/min-1 L/min; and/or the temperature of the chemical vapor deposition is 500 °C -800 °C.

In the embodiments of the present application, the condition of the chemical vapor deposition is controlled to meet the above condition, so that the silane gas enters the porous carbon matrix slowly and is decomposed and deposited uniformly in the pore channels of the porous carbon matrix, thereby preventing the silicon-based particles from being deposited on the surface of the material and reducing the resistivity of the silicon-carbon composite material.

According to a third aspect, a secondary battery is provided and includes: a negative electrode plate. The negative electrode plate includes the silicon-carbon composite material in any embodiment of the first aspect, or includes the silicon-carbon composite material prepared by the method in any embodiment of the second aspect.

According to a fourth aspect, an electrical apparatus is provided. The electrical apparatus includes the secondary battery in any embodiment of the third aspect.

**BRIEF DESCRIPTION OF DRAWINGS**

In order to describe the technical solutions in the embodiments of the present application more clearly, the following briefly introduces the accompanying drawings required for describing the embodiments of the present application. Apparently, the accompanying drawings in the following description show merely some embodiments of the present application, and a person of ordinary skill in the art may also derive other drawings from these accompanying drawings without creative efforts. In the accompanying drawings, the accompanying drawings are not drawn according to an actual ratio.

FIG. 1 is a scanning electron microscope diagram of a porous carbon matrix according to an embodiment of the present application;

FIG. 2 is another scanning electron microscope diagram of a porous carbon matrix according to an embodiment of the present application;

FIG. 3 is a scanning electron microscope diagram of a silicon-carbon composite material according to an embodiment of the present application;

FIG. 4 is another scanning electron microscope diagram of a silicon-carbon composite material according to an embodiment of the present application;

FIG. 5 is an X-ray diffraction peak diagram of a silicon-carbon composite material according to an embodiment of the present application;

FIG. 6 is a schematic flowchart of a preparation method of a silicon-carbon composite material according to an embodiment of the present application;

FIG. 7 is another schematic flowchart of a preparation method of a silicon-carbon composite material according to an embodiment of the present application;

FIG. 8 is a schematic structural diagram of a secondary battery according to an embodiment of the present application;

FIG. 9 is a schematic structural diagram of a battery module according to an embodiment of the present application;

FIG. 10 is a schematic structural diagram of a battery pack according to an embodiment of the present application;

FIG. 11 is another schematic structural diagram of a battery pack according to an embodiment of the present application; and

FIG. 12 is a schematic structural diagram of an electrical apparatus according to an embodiment of the present application.

## DETAILED DESCRIPTION OF THE EMBODIMENTS

Implementations of a silicon-carbon composite material, a preparation method of the silicon-carbon material, a negative electrode plate including the silicon-carbon material, a secondary battery, a battery module, a battery pack, an electrical apparatus and application of the silicon-carbon material to preparation of the secondary battery specifically disclosed in the present application are described in detail below with reference to the accompanying drawings appropriately. However, unnecessary detailed description may be omitted. For example, the detailed description of well-known matters and the repeated description of an actual same structure are omitted. Therefore, the following description is prevented from becoming unnecessarily lengthy, and the understanding of those skilled in the art is facilitated. In addition, the drawings and the following description are provided for those skilled in the art to fully understand the present application, and are not intended to limit the subject recorded in the claims.

"Range" disclosed in the present application is limited in the form of a lower limit and an upper limit, a given range is limited by selecting one lower limit and one upper limit, and the selected lower limit and upper limit define the boundary of a specific range. The range limited in this way may include or not include an end value, and may be combined arbitrarily, that is, any lower limit may be combined with any upper limit to form a range. For example, if ranges of 60-120 and 80-110 are listed for specific parameters, it is understood that the ranges of 60-110 and 80-120 are also expected. In addition, if the minimum range values of 1 and 2, and the maximum range values of 3, 4 and 5 are listed, the following ranges may be all expected: 1-3, 1-4, 1-5, 2-3, 2-4 and 2-5. In the present application, unless otherwise specified, the numeral range "a-b" means the abbreviated representation of any combination of real numbers between a and b, where a and b are both real numbers. For example, the numerical range "0-5" means that all real numbers between "0-5" have been listed in the specification, and "0-5" is only the abbreviated representation of these numerical combinations. In addition, if a certain parameter is expressed as an integer greater than or equal to 2, the parameter is disclosed equivalently, for example, an integer of 2, 3, 4, 5, 6, 7, 8, 9, 10, 11 and 12.

In the description of the present application, it should be noted that, unless otherwise noted, "a plurality of" means two or more; orientation o positional relationships indicated by the terms "upper", "lower", "left", "right", "inner", "outer", and the like are only for the convenience of description of the present application and simplification of description rather than indicating or implying that the referenced device or element must have a particular orientation, be constructed and operated in a particular orientation, and thus are not to be construed as limiting the present application. In addition, the terms "first", "second", "third", and the like are used for descriptive purposes only and are not to be construed as indicating or implying relative importance. "Vertical" is not strictly vertical, but within the allowable range of error. "Parallel" is not strictly parallel, but within the allowable range of error.

Orientation words appearing in the following description are all directions shown in the drawings and do not limit the specific structure of the present application. In the description of the present application, it should also be noted that, unless otherwise expressly specified and limited, the terms "mounted", "connected" and "attached" should be understood in a broad sense, for example, it can be "fixedly connected" or "detachably connected", or "integrally connected"; it can be "directly connected" or "indirectly connected through an intermediate medium". The specific meanings of the above terms in the present application may be understood by those of ordinary skill in the art depending on specific circumstances.

Unless otherwise specified, "including" and "comprising" mentioned in the present application means open or closed. For example, the "including" and "comprising" may mean that other components not listed may be included, or only listed components may be included.

Unless otherwise specified, the term "or" in the present application is inclusive. For example, the phrase "A or B" means "A, B or both A and B". More specifically, any of the following conditions meets the condition "A or B": A is true (or exists) and B is false (or does not exist); A is false (or does not exist) and B is true (or exists); or both A and B are true (or exist).

Unless otherwise specified, all the embodiments and optional embodiments of the present application may be combined with each other to form a new technical solution.

Unless otherwise specified, all the technical features and optional technical features of the present application may be combined with each other to form a new technical solution.

Generally, a secondary battery includes a positive electrode plate, a negative electrode plate, an electrolyte and a separator. In the charging and discharging process of the battery, active ions are intercalated and de-intercalated between the positive electrode plate and the negative electrode plate back and forth. The electrolyte plays a role in conducting ions between the positive electrode plate and the negative electrode plate. The separator is arranged between the positive electrode plate and the negative electrode plate, which can mainly prevent the short circuit between a positive electrode and a negative electrode and allow ions to pass through.

The secondary battery may include a lithium-ion battery, a sodium-ion battery and a magnesium-ion battery. The present application takes the lithium-ion battery as an example. The lithium-ion battery is a typical secondary battery. The lithium-ion battery is also called a rocking chair battery because the lithium-ion battery relies on the chemical reaction of lithium ion de-intercalation and intercalation between the positive and negative electrodes for charging and discharging. In the charging process of the lithium-ion battery, the lithium ions are de-intercalated from the positive electrode, moved and intercalated into the negative electrode; and in the discharging process, the lithium ions are de-intercalated from the negative electrode, moved and intercalated into the positive electrode.

In recent years, the secondary battery has been greatly developed and widely applied to many fields of electrical tools, electronic products, electrical vehicles, aerospace and the like. Higher requirements are put forward for the volume capacity, energy density and cycle performance of the secondary battery.

For a negative electrode material, graphite has become one of the most commonly used negative electrode materials due to its extensive sources, rich reserves and stable electrochemical properties. However, the theoretical capacity of the graphite is low (372mA·h/g), which cannot meet the demand for the secondary batteries with higher volume capacity and energy density. A silicon material also has extensive sources and rich reserves, has extremely high theoretical capacity (4200 mAh/g) and low lithium intercalation potential, also has high chemical stability in an electrolyte solution and is not easy to generate side reaction with the electrolyte, thereby gradually becoming a more ideal negative electrode material of the secondary battery.

In the electrochemical reaction of the secondary battery using silicon as the negative electrode material, on one hand, since the lattice structure of the silicon material is different from that of the graphite, in the intercalation process of the lithium ion, the silicon material will undergo huge volume expansion, and the expansion rate can reach 300%, so that the structure of the negative electrode material can be damaged extremely easily, and the surface of the negative electrode is damaged or falls of a current collector. Furthermore, in the secondary battery using the silicon as the negative electrode material, a solid electrolyte interphase (SEI) film will be formed on the surface of the negative electrode material. The surface of the negative electrode material is continuously damaged due to the expansion of the silicon material, and the SEI film is continuously damaged accordingly and then is regenerated, thereby resulting in unnecessary consumption of the lithium ions and affecting the capacity of the secondary battery. On the other hand, the silicon material belongs to a semiconductor material and has low electrical conductivity and large interface impedance, thereby greatly hindering the conduction of electrons on the surface and the interior of the silicon material and affecting the rate performance of the secondary battery.

In view of this, the present application provides a silicon-carbon composite material. The silicon-carbon composite material includes a porous carbon matrix and silicon-based particles distributed in the porous carbon matrix. The silicon-based particles are distributed in mutually crosslinked pore channels of the porous carbon matrix, so that the silicon-carbon composite material has extremely high volume capacity and energy density. The porous carbon matrix has a three-dimensional net structure and high electrical conductivity, and the volume expansion of the silicon-based particles can be accommodated and limited in the space inside the mutually crosslinked pore channels, so that the silicon-carbon composite material has high electrical conductivity, rate performance and cycle performance.

It should be understood that the "lithium intercalation" and "intercalation" processes mentioned in the present application refer to a process in which lithium ions are intercalated in a positive electrode material and a negative electrode material due to an electrochemical reaction; and the "removal", "lithium de-intercalation" and "de-intercalation" mentioned in the present application refer to a process in which the lithium ions are de-intercalated from the positive electrode material and the negative electrode material due to the electrochemical reaction.

Firstly, the present application provides a silicon-carbon composite material. The silicon-carbon composite material includes a porous carbon matrix and silicon-based particles. The porous carbon matrix internally includes a plurality of pore channels with a width of 5 nm-50 nm. The silicon-based particles are distributed in the pore channels, and the porous carbon matrix meets: $1.0 \leq V_{total}/S_{total} \leq 10$ and the unit is: $10^{-7}$ cm, where $S_{total}$ is the total surface area occupied by the pore channels with the width of 5 nm-50 nm, and the measurement unit is: $\times 10^4$ cm$^2$/g; and $V_{total}$ is the total pore volume occupied by the pore channels with the width of 5 nm-50 nm, and the measurement unit is: cm$^3$/g.

Specifically, $V_{total}/S_{total}$ may be 1, 2, 3, 4, 5, 6, 7, 8, 9 and 10, or the value thereof is within a range obtained by combining any two of the above values.

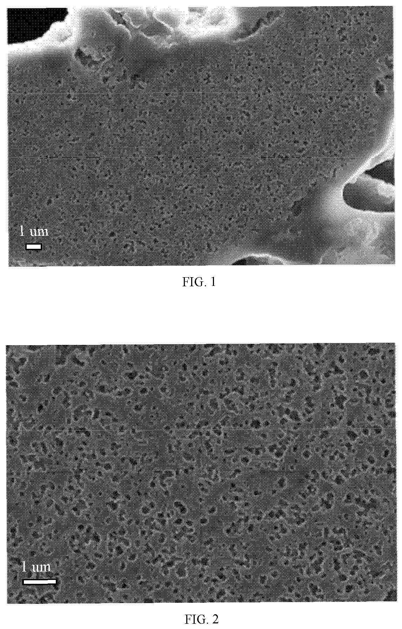

FIG. 1 and FIG. 2 are scanning electron microscope (SEM) diagrams of a porous carbon matrix according to an embodiment of the present application. Referring to FIG. 1 and FIG. 2, the porous carbon matrix has rich pore channel structures and mutually crosslinked three-dimensional network-shaped carbon skeletons.

$V_{total}/S_{total}$ represents an average pore length of the pore channels in the porous carbon matrix. The porous carbon matrix forms the carbon skeletons with the three-dimensional network structures due to the plurality of pore channel structures therein. The carbon skeleton serves as an electronic conductor, and a conducting model of the carbon skeleton may be compared with a parallel circuit. The parallel circuit Ohm's law meets a formula (I):

a.

$$1/R_{total} = 1/R_1 + 1/R_2 + 1/R_3 + ... + 1/R_m \text{ Formula (I)}$$

where $R_{total}$ is the total resistance of the parallel circuit, $R_1$ is the resistance of a first parallel branch, $R_2$ is the resistance of a second parallel branch, $R_3$ is the resistance of a third parallel branch, $R_m$ is the resistance of an m$^{th}$ parallel branch, and m is an integer greater than or equal to 2. Therefore, the unit pore channel length of the porous carbon matrix is controlled within a small range, so that more carbon skeletons can be connected in parallel in the porous carbon matrix, and lower resistivity can be achieved.

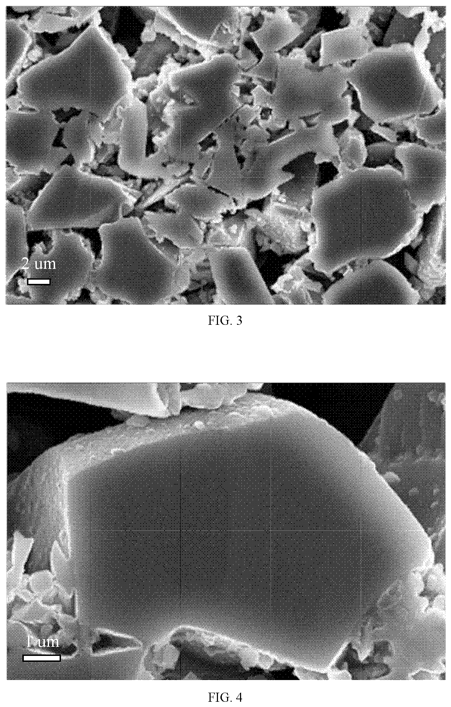

FIG. 3 and FIG. 4 are scanning electron microscope (SEM) diagrams of a silicon-carbon composite material according to an embodiment of the present application. Referring to FIG. 1 to FIG. 4, the silicon-carbon composite material provided by the present application is mainly composed of a porous carbon matrix and silicon-based particles distributed in pore channel structures of the porous carbon matrix. The porous carbon matrix meeting the above condition is different from the general carbon matrix and has a plurality of pore channel structures therein. At least two of the plurality of pore channel structures communicate with each other, so that the porous carbon matrix forms a three-dimensional net structure. On one hand, the porous carbon matrix has high electrical conductivity, and the electron transmission efficiency of a silicon-carbon interface can be effectively improved after the silicon-based particles are compounded on the porous carbon matrix; and on the other hand, the rich crosslinked pore channel structures can effectively accommodate and limit the volume expansion of the silicon-based particles in the battery cycle process, so that the structural stability of the silicon-carbon composite material can be effectively improved, and structural damage caused by the volume expansion of the silicon-based particles can be reduced. In the silicon-carbon composite material shown in FIG. 3 and FIG. 4, the silicon-based particles are distributed in the pore channel structures uniformly. Therefore, when the silicon-carbon composite material is applied to the negative electrode of the battery, the volume capacity and energy density of the battery can be effectively increased, and high cycle performance and rate performance can be achieved.

Optionally, in some embodiments, $1.0 \leq V_{total}/S_{total} \leq 10$, optionally, $2 \leq V_{total}/S_{total} \leq 5$, and the unit is: $\times 10^{-7}$ cm.

Specifically, $V_{total}/S_{total}$ may be 2, 2.5, 3, 3.5, 4, 4.5 and 5, or the value thereof is within a range obtained by combining any two of the above values.

In this embodiment, the electrical conductivity of the porous carbon matrix can be further improved by further reducing the length range of the pore channels in the porous carbon matrix, thereby improving the electrical conductivity of the silicon-carbon composite material and helping to improve the cycle stability and rate performance of the battery.

Optionally, in some embodiments, $1 \leq S_{total} \leq 50$, optionally, $1 \leq S_{total} \leq 30$, and the unit is: $\times 10^4$ cm$^2$/g.

Specifically, $S_{total}$ may be 1, 3, 4, 5, 6, 7, 8, 9, 10, 12, 14, 16, 18, 20, 22, 24, 26, 28, 30, 32, 34, 36, 38, 40, 42, 44, 46, 48 and 50, or the value thereof is within a range obtained by combining any two of the above values.

Optionally, in some embodiments, $0.002 \leq V_{total} \leq 0.250$, optionally, $0.004 \leq V_{total} \leq 0.200$, and the unit is: cm$^3$/g.

Specifically, $V_{total}$ may be 0.002, 0.004, 0.007, 0.008, 0.009, 0.10, 0.11, 0.12, 0.13, 0.14, 0.15, 0.16, 0.17, 0.18, 0.18, 0.20, 0.21, 0.22, 0.23, 0.24 and 0.25, or the value combination thereof is within a range obtained by combining any two of the above values.

In this embodiment, the porous carbon matrix meeting the above condition has a three-dimensional crosslinked net structure and large specific surface area, so that the surface of the porous carbon matrix has sufficient space for the distribution of the silicon-based particles. Therefore, the silicon-carbon composite material obtained by compounding the porous carbon matrix and the silicon-based particles has extremely high volume capacity and energy density. Meanwhile, the pore channels in the porous carbon matrix meeting the above condition has sufficient volume and can accommodate and limit the expansion of the silicon-based particles compounded in the pore channels in the battery cycle process, thereby maintaining the structural stability of the silicon-carbon composite material in the battery cycle process and effectively improving the cycle performance of the battery.

Optionally, in some embodiments, the grain size of the silicon-based particles is less than or equal to 20 nm, preferably, 2 nm-10 nm.

Optionally, in some embodiments, the volume particle size distribution of the porous carbon matrix is: $D_{v50} \leq 10$ $\mu$m, optionally, $5 \leq D_{v50} \leq 10$ $\mu$m; and/or the volume particle size distribution of the porous carbon matrix is: $D_{v90} \leq 20$ $\mu$m, optionally, $10 \leq D_{v90} \leq 15 \mu$m.

Specifically, the porous carbon matrix is crushed before being compounded with the silicon-based particles to form the silicon-carbon composite material, so that the granular porous carbon matrix. The micro-sized porous carbon matrix and the silicon-based particles are compounded, which is beneficial for the silicon-based particles to enter and be deposited in the pore channels of the porous carbon matrix instead of being deposited on the surfaces of the carbon skeletons. If the silicon-based particles are only deposited on the surface, the porous carbon matrix with high electrical conductivity will be wrapped by the silicon-based particles with low electrical conductivity, thereby destroying the high electrical conductivity of the whole silicon-carbon composite material. Therefore, the porous carbon matrix is crushed before compounding, which is beneficial for the silicon-based particles to be uniformly deposited in the pore channels and helps to improve the electrical conductivity of the silicon-carbon composite material.

Optionally, in some embodiments, the content of the silicon-based particles in the silicon-carbon composite material is 25%-65%, optionally, 35%-45%.

Specifically, the content of the silicon-based particles in the silicon-carbon composite material may be 25%, 26%, 27%, 28%, 29%, 30%, 31%, 32%, 33%, 34%, 35%, 36%, 37%, 38%, 39%, 40%, 41%, 42%, 43%, 44% and 45%, or the value combination thereof is within a range obtained by combining any two of the above values.

In this embodiment, the content of the silicon-based particles in the silicon-carbon composite material is controlled within an appropriate range. On one hand, sufficient silicon-based particles can be compounded in the silicon-carbon composite material, and the volume capacity and energy density of the silicon-carbon composite material can be increased as much as possible; and on the other hand, due to the low electrical conductivity of the silicon-based particles, the content of the silicon-based particles is controlled within an appropriate range, which can avoid the influence on the electrical conductivity of the silicon-carbon composite material caused by the excessive silicon-based particles in the silicon-carbon composite material. Therefore, the silicon-carbon composite material can have high specific capacity and high electrical conductivity by controlling the content of the silicon-based particles in the silicon-carbon composite material.

Optionally, in some embodiments, the powder resistivity of the porous carbon matrix under the pressure of 4 MPa is 1 $\Omega$/cm-300 $\Omega$/cm, optionally, 1 $\Omega$/cm-100 $\Omega$/cm.

Specifically, the powder resistivity of the porous carbon matrix under the pressure of 4 MPa may be 1 $\Omega$/cm, 5 $\Omega$/cm, 10 $\Omega$/cm, 15 $\Omega$/cm, 20 $\Omega$/cm, 25 $\Omega$/cm, 30 $\Omega$/cm, 35 $\Omega$/cm, 40 $\Omega$/cm, 45 $\Omega$/cm, 50 $\Omega$/cm, 55 $\Omega$/cm, 60 $\Omega$/cm, 65 $\Omega$/cm, 70 $\Omega$/cm, 75 $\Omega$/cm, 80 $\Omega$/cm, 85 $\Omega$/cm, 90 $\Omega$/cm, 95 $\Omega$/cm, 100 $\Omega$/cm, 150 $\Omega$/cm, 200 $\Omega$/cm, 250 $\Omega$/cm and 300 $\Omega$/cm, or the value combination thereof is within a range obtained by combining any two of the above values.

In this embodiment, a porous carbon bracket has low resistivity due to the crosslinked net structure. After the silicon-based particles are compounded, the silicon-carbon composite material can have low resistivity and show high electrical conductivity when serving as an electrode active material, thereby improving the cycle stability of the battery.

In some embodiments, the powder resistivity R of the silicon-carbon composite material under the pressure of 12 MPa is less than or equal to 300 $\Omega$/cm, optionally, 1 $\Omega$/cm-200 $\Omega$/cm; and/or the powder resistivity R of the silicon-carbon composite material under the pressure of 16 MPa is less than or equal to 200 $\Omega$/cm, optionally, 1 $\Omega$/cm-100 $\Omega$/cm.

Specifically, the powder resistivity of the silicon-carbon composite material under the pressure of 12 MPa may be 1 $\Omega$/cm, 5 $\Omega$/cm, 10 $\Omega$/cm, 15 $\Omega$/cm, 20 $\Omega$/cm, 25 $\Omega$/cm, 30 $\Omega$/cm, 35 $\Omega$/cm, 40 $\Omega$/cm, 45 $\Omega$/cm, 50 $\Omega$/cm, 55 $\Omega$/cm, 60 $\Omega$/cm, 65 $\Omega$/cm, 70 $\Omega$/cm, 75 $\Omega$/cm, 80 $\Omega$/cm, 85 $\Omega$/cm, 90 $\Omega$/cm, 95 $\Omega$/cm, 100 $\Omega$/cm, 150 $\Omega$/cm, 200 $\Omega$/cm, 250 $\Omega$/cm and 300 $\Omega$/cm, or the value combination thereof is within a range obtained by combining any two of the above values. Specifically, the powder resistivity of the silicon-carbon composite material under the pressure of 16 MPa may be 1 $\Omega$/cm, 5 $\Omega$/cm, 10 $\Omega$/cm, 15 $\Omega$/cm, 20 $\Omega$/cm, 25 $\Omega$/cm, 30 $\Omega$/cm, 35 $\Omega$/cm, 40 $\Omega$/cm, 45 $\Omega$/cm, 50 $\Omega$/cm, 55 $\Omega$/cm, 60 $\Omega$/cm, 65 $\Omega$/cm, 70 $\Omega$/cm, 75 $\Omega$/cm, 80 $\Omega$/cm, 85 $\Omega$/cm, 90 $\Omega$/cm, 95 $\Omega$/cm, 100 $\Omega$/cm, 150 $\Omega$/cm and 200 $\Omega$/cm, or the value combination thereof is within a range obtained by combining any two of the above values.

Optionally, in some embodiments, the silicon-carbon composite material meets one or more of the following (1) to (6):

(1) the volume particle size distribution of the silicon-carbon composite material is Dv10≤5 μm, optionally, 3≤Dv10≤5 μm;

(2) the volume particle size distribution of the silicon-carbon composite material is Dv50≤10 μm, optionally, 5≤Dv50≤10 μm;

(3) the volume particle size distribution of the silicon-carbon composite material is Dv90<20 μm, optionally, 10≤Dv50≤15 μm;

(4) the particle size distribution of the silicon-carbon composite material meets: (Dv90-Dv10)/Dv50≤1.8, optionally, 1.5≤(Dv90-Dv10)/Dv50≤1.7;

(5) the compaction density of the silicon-carbon composite material under the pressure of 2 MPa is 1 g/cm³-1.5 g/cm³, optionally, 1.1 g/cm³-1.3 g/cm³; and

(6) the specific surface area (SSA) of the silicon-carbon composite material is 2 m²/g -10 m²/g, optionally, 3 m²/g -7 m²/g.

Specifically, the silicon-carbon composite material obtained by the silicon-carbon composite material obtained by compounding the porous carbon matrix and the silicon-based particles has at least one of the following properties (1) to (6).

For example, the compaction density of the silicon-carbon composite material under the pressure of 2 MPa is 1 g/cm³1.1 g/cm³, 1.2 g/cm³, 1.3 g/cm³, 1.4 g/cm³ and 1.5 g/cm³, or the value thereof is within a range obtained by combining any two of the above values.

For another example, the SSA of the silicon-carbon composite material may be 2 m²/g, 2.5 m²/g, 3 m²/g, 3.5 m²/g, 4 m²/g, 4.5 m²/g, 5 m²/g, 5.5 m²/g, 6 m²/g, 6.5 m²/g, 7 m²/g, 7.5 m²/g, 8 m²/g, 8.5 m²/g, 9 m²/g, 9.5 m²/g and 10 m²/g.

Optionally, in some embodiments, the peak value of an X-ray diffraction (XRD) peak of the silicon-carbon composite material between the diffraction angle 28° and 29° is denoted as P1, and the peak value of an XRD peak of the silicon-based particles between the diffraction angle 42° and 45° is denoted as P2, then 2≤P1/P2≤4, optionally, 600≤P1≤800, and optionally, 200≤P2≤400.

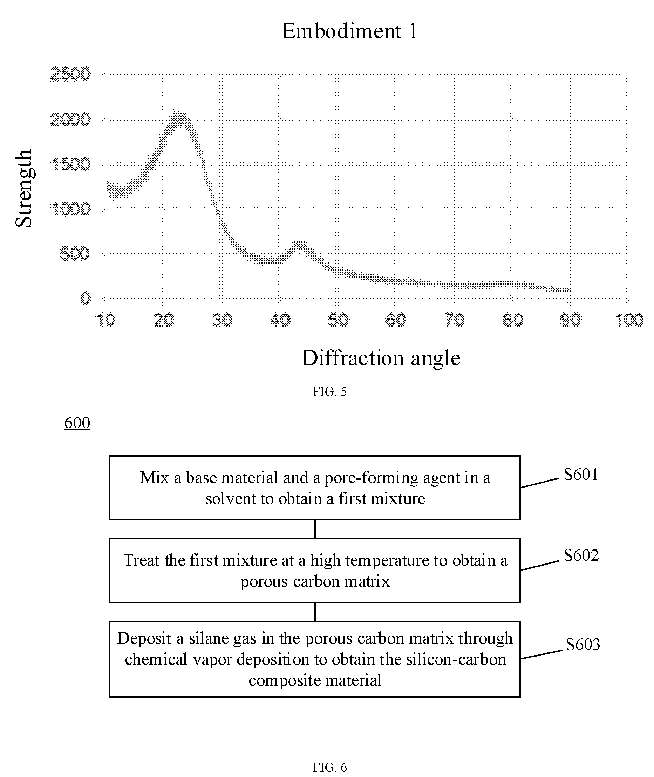

FIG. 5 is an XRD peak diagram of a silicon-carbon composite material according to an embodiment of the present application.

As shown in FIG. 5, the silicon-carbon composite material has an obvious diffraction peak within the range of the diffraction angle of 28°-29° and 42°-45°, where the diffraction angle of 28°-29° is a feature peak of the carbon material, and the diffraction angle of 42°-45° is a feature peak of the silicon material.

To obtain the silicon-carbon composite material, the embodiment of the present application further provides a preparation method of a silicon-carbon composite material. FIG. 6 is a schematic flowchart of a preparation method of a silicon-carbon composite material according to an embodiment of the present application.

As shown in FIG. 6, the preparation method 600 of the silicon-carbon composite material includes:

S601: mix a base material and a pore-forming agent in a solvent to obtain a first mixture;

S602: treat the first mixture at a high temperature to obtain a porous carbon matrix; and

S603: deposit a silane gas in the porous carbon matrix through chemical vapor deposition (CVD) to obtain the silicon-carbon composite material.

Optionally, the silicon-based particles include at least one of silicon oxide, nano-silicon and alloy silicon. The silicon oxide includes but is not limited to: silicon monoxide, silicon dioxide and the like. The alloy silicon includes but is not limited to silicone alloy, ferrosilicon alloy, silicon-aluminum alloy and the like.

Optionally, a base material includes at least one of resin, sugar or other polymers. Optionally, the resin includes but is not limited to linear phenolic resin, soluble phenolic resin, epoxy resin, polyurethane and the like. Optionally, the sugar includes but is not limited to glucose, sucrose, fructose, starch, amylopectin, amylose, lignin, dextrin and maltodextrin. Optionally, other polymers include but are not limited to acrylate, a styrene polymer, carbamate, rubber, nylon and the like.

Optionally, the pore-forming agent includes at least one of sodium chloride, potassium chloride, zinc chloride, sodium carbonate, potassium carbonate and zinc carbonate.

Optionally, the solvent includes but is not limited to water or alcohol. For example, the solvent may further be a mixture of water and alcohol, that is, an alcohol solution. The alcohol includes but is not limited to methanol, ethanol, ethylene glycol, polyethylene glycol, glycerol, isopropanol or polyalcohol.

Optionally, in S601, a mass ratio of the base material to the pore-forming agent is 1:5-10:1, optionally, 2:1-5:1.

Specifically, the mass ratio of the base material to the pore-forming agent is 1:5, 1:4, 1:3, 1:2, 1:1, 2:1, 3:1, 4:1, 5:1, 6:1, 7:1, 8:1, 9:1 and 10:1, or the value thereof is within a range obtained by any two of the above values.

In this embodiment, the use amount of the pore-forming agent can be determined according to the use amount of the base material, so that the mass ratio of the base material to the pore-forming agent is within an appropriate range, the situation that sufficient gas cannot be generated to form a narrow and long pore channel due to the too small use amount can be avoided, and the situation that local reaction is violent to rapidly generate a large amount of gas due to the excessive use amount of the pore-forming agent to cause large pores can be avoided. In other words, the shape and size of the pore channel in the porous carbon matrix can be effectively regulated and controlled by controlling the mass ratio of the base material to the pore-forming agent, so that the pore channel structure with an appropriate size and narrow and a long shape can be prepared.

Optionally, in S601, a mass ratio of the base material to the pore-forming agent is 1:100-10:1, optionally, 1:2-10:1.

Specifically, the mass ratio of the base material to the pore-forming agent is 1:100, 1:90, 1:80, 1:70, 1:60, 1:50, 1:40, 1:30, 1:20, 1:10, 1:9, 1:8, 1:7, 1:6, 1:5, 1:4, 1:3, 1:2, 1:1, 2:1, 3:1, 4:1, 5:1, 5:1, 7:1, 8:1, 9:1 and 10:1, or the value thereof is within a range obtained by any two of the above values.

In this embodiment, the use amount of the solvent is determined according to the use amount of the base material, so that the mass ratio of the base material to the solvent is within an appropriate range, the situation that after the pore-forming agent generates gas, the gas cannot be dispersed timely due to excessively few solvents and excessively high viscosity of the first mixture to cause the pore size larger or longer can be avoided, and the situation that after the pore-forming agent generates gas, the gas is discharged rapidly from the first mixture due to the excessive solvent and excessively low viscosity of the first mixture to cause the pore-forming failure can be avoided. In other words, the viscosity of the first mixture can be effectively regulated and controlled by controlling the mass ratio of the base material to the solvent, so that the gas can be uniformly dispersed in the first mixture after the pore-forming agent generates the gas, thereby ensuring the distribution uniformity and appropriate size and shape of the pore channels in the porous carbon matrix.

Optionally, in S601, the mix a base material and a pore-forming agent in a solvent includes: mix the base material and the pore-forming agent in the solvent through stirring.

Specifically, there may be many ways to uniformly mix the base material, the pore-forming agent and the solvent, for example: stirring, heating and stirring, and stirring under a high pressure. Taking the stirring way as an example, the solvent may be placed in a container with a stirring apparatus such as a stirrer and spiral stirring, and the stirring apparatus stirs the solvent at a certain speed. In this process, the base material and the pore-forming agent are added in the solvent, and are stirred for a certain time to obtain the first mixture with a uniform volume phase. It should be understood that the process of adding the base material in the solvent may be: adding the base material and then adding the pore-forming agent, or adding the pore-forming agent and then adding the base material, or adding the base material and the pore-forming agent at the same time, which is not limited by the embodiments of the present application.

Optionally, the stirring speed is 100 rpm/min-1500 rpm/min, optionally, 200 rpm/min-1000 rpm/min.

Specifically, the stirring speed may be 100 rpm/min, 200 rpm/min, 300 rpm/min, 400 rpm/min, 500 rpm/min, 600 rpm/min, 700 rpm/min, 800 rpm/min, 900 rpm/min, 1000 rpm/min, 1100 rpm/min, 1200 rpm/min, 1300 rpm/min, 1400 rpm/min and 1500 rpm/min, or the value thereof is within a range obtained by any two of the above values.

Under the above preferred stirring speed, the base material, the pore-forming agent and the solvent can be mixed rapidly and uniformly, and waste caused by splattering of the liquid mixture due to excessively high rotating speed can be avoided.

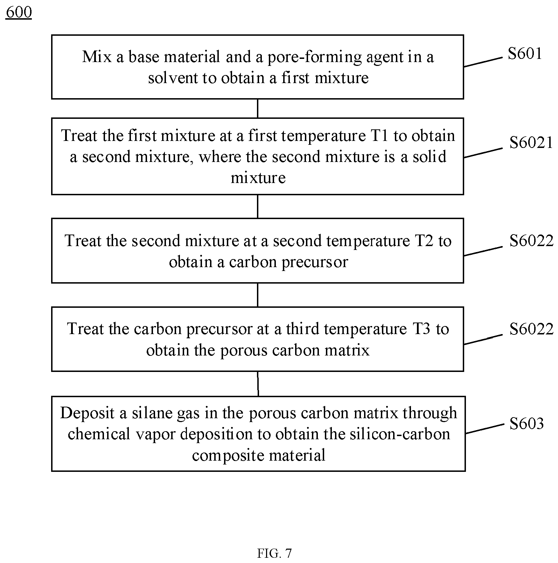

FIG. 7 is another schematic flowchart of a preparation method 600 of a silicon-carbon composite material according to an embodiment of the present application.

As shown in FIG. 7, in S602, the treating the first mixture at a high temperature to obtain a porous carbon matrix includes:

S6021: treat the first mixture at a first temperature T1 to obtain a second mixture, where the second mixture is a solid mixture;

S6022: treat the second mixture at a second temperature T2 to obtain a carbon precursor; and

S6023: treat the carbon precursor at a third temperature T3 to obtain the porous carbon matrix.

Specifically, in S6021, a large number of solvents are volatilized in this process, and the first mixture with flowability is preliminarily solidified at T1, so that the first mixture is converted into a solid second mixture, and in the second mixture, the pore-forming agent is uniformly dispersed in the matrix. In S6022, the second mixture is treated at T2, so that the solvent is further volatilized, the second mixture is further solidified into the carbon precursor, and the carbon precursor has a more stable structure compared with the second mixture. In S6023, the carbon precursor is treated at T3, the pore-forming agent is decomposed at T3 to generate a gas so as to form pores in the carbon precursor, and the carbon precursor is subjected to reaction at T3 to generate a carbon skeleton with a porous structure, that is, the porous carbon matrix.

In this embodiment, the distribution uniformity of the pore-forming agent in the carbon precursor can be effectively regulated and controlled through the multi-temperature and multi-step process, so that the first mixture is converted into the porous carbon matrix with uniform crosslinked pore channel structures inside.

Optionally, in S6021, T1 is 40°C-80°C, optionally, T1 is 40°C -60°C.

Specifically, T1 may be 40°C, 45°C, 50°C, 55°C, 60°C, 65°C, 70°C, 75°C and 80°C, or the value thereof is within a range obtained by any two of the above values.

In this embodiment, T1 is the preliminary solidification temperature of the first mixture. The T1 is controlled within an appropriate range, so that the situation that T1 is excessively high, the pore-forming agent is excessively dispersed, the pore channels cannot be mutually crosslinked in the subsequent pore-forming process and a large number of micro-pores appear can be avoided, and the situation that excessively low T1 is not conducive to the solidification and formation of the first mixture and the subsequent preparation process is affected can be avoided.

Optionally, in S6022, T2 is 100°C-200°C, optionally, T2 is 130°C-180°C.

Specifically, T2 may be 130°C, 140°C, 150°C, 160°C, 170°C, 180°C, 190°C and 200°C, or the value thereof is within a range obtained by any two of the above values.

Optionally, in S6023, T3 is 600°C-1200°C, optionally, T3 is 800°C -1000°C.

Specifically, T3 may be 600°C, 700°C, 800°C, 900°C, 1000°C, 1100°C and 1200°C, or the value thereof is within a range obtained by any two of the above values.

Optionally, before S6022, the preparation method 600 further includes: crush the second mixture.

Specifically, after the first mixture is preliminarily solidified into the second mixture, the second mixture may be treated into powdery solid through the process steps of coarse crushing, fine crushing and grinding, that is, the second mixture is crushed. The second mixture is treated at T2 after being crushed, thereby avoiding the situation that the solvent in the block-shaped second mixture cannot be volatilized or cannot be further solidified.

Optionally, before S6023, the preparation method 600 further includes: crush the carbon precursor. Optionally, after the carbon precursor is crushed, the particle size of the carbon precursor is 1 $\mu$m-1000 $\mu$m, optionally, 5 $\mu$m-100 $\mu$m.

Specifically, after the carbon precursor is obtained, the obtained carbon precursor may be further crushed, the carbon precursor is treated into micro-sized particles, and then the carbon precursor is treated at T3, thereby increasing the reaction degree of a carbonization reaction, and avoiding the situation that the large granular carbon precursor is carbonized only on the surface and not inside. Therefore, the quality of the prepared porous carbon matrix is improved. The particle size of the crushed carbon precursor may be 1 $\mu$m, 2 $\mu$m, 3 $\mu$m, 4 $\mu$m, 5 $\mu$m, 6 $\mu$m, 7 $\mu$m, 8 $\mu$m, 9 $\mu$m, 10 $\mu$m, 50 $\mu$m, 100 $\mu$m, 150 $\mu$m, 200 $\mu$m, 300 $\mu$m, 400 $\mu$m, 500 $\mu$m, 600 $\mu$m, 700 $\mu$m, 800 $\mu$m, 900 $\mu$m and 1000 $\mu$m, or the value thereof is within a range obtained by any two of the above values.

Optionally, in S6023, the treat the carbon precursor at T3 includes: treat the carbon precursor at T3 in an inert gas. Optionally, the inert gas includes at least one of nitrogen ($N_2$), argon (Ar) and helium (He).

Specifically, the carbon precursor is treated at a high temperature in the inert gas, so that the carbon precursor can be protected from reacting with oxygen, and the carbon precursor is subjected to carbonization reaction, thereby obtaining the porous carbon matrix with rich pore channel structures.

Optionally, before S6023, the preparation method 600 further includes: perform impurity removal and/or demagnetization on the porous carbon matrix. The carbon precursor is further screened through the technical processes of impurity removal and demagnetization to obtain micro-sized carbon precursor particles which are more in line with requirements, thereby improving the quality of the prepared porous carbon matrix.

Optionally, in S604, in the CVD process, the porous carbon matrix is usually placed in a silicon-containing gas at a high temperature, so that the silicon in the silicon-containing gas can be deposited in the pore channels of the porous carbon to generate silicon-based particles. The silicon-containing gas includes at least one of a silane gas, silicon dichloride, silicon trichloride and silicon tetrachloride. The silicon-containing gas may further include hydrogen, the inert gas and other gases. In a case that the silicon-containing gas includes a plurality of gases, taking the case where the silicon-containing gas includes the silicon dichloride and nitrogen as an example, the silicon-containing gas may include 01%-1% by volume of silicon dichloride and the balance of nitrogen, or the silicon-containing gas may include 1%-10% by volume of silicon dichloride and the balance of nitrogen, or the silicon-containing gas may include 10%-50% by volume of silicon dichloride and the balance of nitrogen, or the silicon-containing gas may include more than 50% by volume of silicon dichloride and the balance of nitrogen.

Preferably, the CVD atmosphere is a mixed gas of the silane gas and the hydrogen. Optionally, the silane gas accounts for 10%-50% of the volume of the mixed gas.

Optionally, the temperature of the CVD is 500°C-800°C. Specifically, the temperature of the CVD may be 500°C, 550°C, 600°C, 650°C, 700°C, 750°C and 800°C, or the value thereof is within a range obtained by any two of the above values.

Optionally, the flow of the silane gas of the CVD is 0.5 L/min-1 L/min. Specifically, the flow of the silicon-containing substance may be 0.5 L/min, 0.55 L/min, 0.6 L/min, 0.65 L/min, 0.7 L/min, 0.75 L/min, 0.8 L/min, 0.85 L/min, 0.9 L/min, 0.95 L/min and 1 L/min, or the value thereof is within a range obtained by any two of the above values.

In this embodiment, the porous carbon matrix and the silicon-based particles are compounded through CVD to obtain the silicon-carbon composite material. The CVD is controlled to meet the above condition, so that the silicon in the silicon-containing gas can be uniformly deposited in the pore channels of the porous carbon matrix, and the silicon-carbon composite material with extremely high electrical conductivity can be obtained.

Optionally, in some other embodiments, the porous carbon matrix and the silicon-based particles may be compounded through plasma enhanced chemical vapor deposition (PECVD).

In the preparation method 600 of this embodiment, the base material and the pore-forming agent are firstly dispersed uniformly in the solvent, and in the subsequent high-temperature treatment process, the solvent and the pore-forming agent act jointly for pore formation to obtain narrow and long pore channels that are crosslinked mutually. The carbon skeleton with the special pore channel structures has a three-dimensional net structure, so that the porous carbon matrix has low resistivity. In the process of compounding the silicon-based particles and the porous carbon matrix through chemical vapor deposition, the flow of the silane gas is controlled within an appropriate range, so that the silane gas enters the pore channels of the porous carbon matrix slowly and completely and are decomposed and deposited in the pore channels uniformly, thereby preventing the silicon-based particles from being deposited only on the surface of the material. Therefore, the silicon-carbon interface completely extends into the silicon-carbon composite material, and compared with the ordinary silicon-carbon material, the electrical conductivity of the material is significantly improved. The resistivity of the silicon-carbon composite material prepared by the method 600 is usually 100 $\Omega$/cm-10000 $\Omega$/cm.

The embodiments of the present application further provide a negative electrode plate, a secondary battery, a battery module, a battery pack and an electrical apparatus. Then, the negative electrode plate, the secondary battery, the battery module, the battery pack and the electrical apparatus provided by the present application are described appropriately with reference to the accompanying drawings.

[Negative electrode plate]

The negative electrode plate usually includes a negative electrode current collector and a negative electrode film arranged on at least one surface of the negative electrode current collector. The negative electrode film includes a negative electrode active material.

As an example, the negative electrode current collector has two opposite surfaces in a thickness direction of the negative electrode current collector; and the negative electrode film is arranged on any one or two of the two opposite surfaces of the negative electrode current collector.

In one example, the negative electrode active material is the silicon-carbon composite material provided by any embodiment of the present application.

Optionally, in one embodiment, the negative electrode active material may further include a mixture formed by mixing at least one of other negative electrode active materials for the battery known in the art and the silicon-carbon composite material provided by any embodiment of the present application. As an example, other negative electrode active materials may include at least one of the following materials: artificial graphite, natural graphite, soft carbon, hard carbon, elemental silicon, silicon oxide, a silicon-carbon composite material, a silicon-nitrogen complex, silicon alloy, a tin-based material and lithium titanate. The tin-based material may be selected from at least one of elemental tin, tin oxide and tin alloy.

Optionally, in one embodiment, the negative electrode current collector may adopt a metal foil or a composite current collector. For example, as the metal foil, a copper foil may be adopted. The composite current collector may include a macro-molecular material base layer, and a metal layer formed on at least one surface of the macro-molecular material base layer. The composite current collector may be formed by forming a metal material (copper, copper alloy, nickel, nickel alloy, titanium, titanium alloy, silver and silver alloy) on the macro-molecular material base material (such as polypropylene (PP), polyethylene terephthalate (PET), polybutylene terephthalate (PBT), polystyrene (PS) and polyethylene (PE)).

Optionally, in one embodiment, the negative electrode film includes a binding agent. The binding agent may be selected from at least one of butadiene styrene rubber (SBR), polyacrylic acid (PAA), polyacrylic acid sodium (PAAS), polyacrylamide (PAM), polyvinly alcohol (PVA), sodium alginate (SA), polymethylacrylic acid (PMAA) and carboxymethyl chitosan (CMCS).

Optionally, in one embodiment, the negative electrode film includes a conductive agent. The conductive agent may be selected from at least one of superconductive carbon, acetylene black, carbon black, Ketjen black, a carbon dot, a carbon nanotube, graphene and carbon nanofiber.

Optionally, in one embodiment, the negative electrode film further includes other aids, for example, a thickening agent (such as carboxymethylcelulose sodium (CMC-Na)).

Optionally, in one embodiment, the negative electrode plate may be prepared by the following ways: disperse the components for preparing the negative electrode plate, for example, the negative electrode active material, the conductive agent, the binding agent and any other components, into the solvent (such as deionized water) to form a negative electrode slurry; and coat the negative electrode current collector with the negative electrode slurry and then obtain the negative electrode plate through the processes of drying and cold pressing.

[Positive electrode plate]

The positive electrode plate includes a positive electrode current collector, and a positive electrode film arranged on at least one surface of the positive electrode current collector. The positive electrode film includes the positive electrode active material according to the first aspect of the present application.

As an example, the positive electrode current collector has two opposite surfaces in a thickness direction of the positive electrode current collector; and the positive electrode film is arranged on any one or two of the two opposite surfaces of the positive electrode current collector.

Optionally, in one embodiment, the positive electrode active material may adopt the positive electrode active material for the battery known in the art. As an example, the positive electrode active material may include at least one of the following materials: lithium-containing phosphate with an olivine structure, lithium transition metal oxide, and respective modified compounds. However, the present application is not limited to these materials, and may also use other traditional materials that can be used as the positive electrode active material of the battery. Only one or two of these positive electrode active materials may be used. The example of the lithium transition metal oxide may include but not limited to at least one of lithium cobalt oxide (such as $LiCoO_2$), lithium nickel oxide (such as $LiNiO_2$), lithium manganese oxide (such as $LiMnO_2$ and $LiMn_2O_4$), lithium nickel cobalt oxide, lithium manganese cobalt oxide, lithium manganese nickel oxide, lithium nickel cobalt manganese oxide (such as $LiNi_{1/3}Co_{1/3}Mn_{1/3}O_2$ (that may be referred to as NCM333 for short), $LiNi_{0.5}Co_{0.2}Mn_{0.3}O_2$ (that may be referred to as NCM523 for short), $LiNi_{0.5}Co_{0.25}Mn_{0.25}O_2$ (that may be referred to as NCM211 for short), $LiNi_{0.6}Co_{0.2}Mn_{0.2}O_2$ (that may be referred to as NCM622 for short) and $LiNi_{0.8}Co_{0.1}Mn_{0.1}O_2$ (that may be referred to as NCM811 for short) ), lithium nickel cobalt aluminum oxide (such as $LiNi_{0.85}Co_{0.15}Al_{0.05}O_2$), and modified compounds thereof. The example of the lithium-containing phosphate with the olivine structure may include but not limited to at least one of lithium iron phosphate (such as $LiFePO_4$ (that may be referred to as LFP for short)), a composite material of lithium iron phosphate and carbon, lithium manganese phosphate (such as $LiMnPO_4$), a composite material of lithium manganese phosphate and carbon, lithium ferromanganese phosphate and a composite material of lithium ferromanganese phosphate and carbon.

In some embodiments, the positive electrode film may optionally include a binding agent. As an example, the binding agent may include at least one of polyvinylidene fluoride (PVDF), polytetrafluoroethylene (PTFE), a vinylidene fluoride-tetrafluoroethylene-propylene terpolymer, a vinylidene fluoride-hexafluoropropylene-tetrafluoroethylene terpolymer, a tetrafluoroethylene-hexafluoropropylene copolymer and fluorinated acrylate resin.

Optionally, in one embodiment, the positive electrode current collector may adopt a metal foil or a composite current collector. For example, as the metal foil, an aluminum foil may be adopted. The composite current collector may include a macro-molecular material base layer, and a metal layer formed on at least one surface of the macro-molecular material base layer. The composite current collector may be formed by forming a metal material (aluminum, aluminum alloy, nickel, nickel alloy, titanium, titanium alloy, silver and silver alloy) on the macro-molecular material base material (such as polypropylene (PP), polyethylene terephthalate (PET), polybutylene terephthalate (PBT), polystyrene (PS) and polyethylene (PE)).

Optionally, in one embodiment, the positive electrode film further includes a conductive agent. As an example, the conductive agent may include at least one of superconductive carbon, acetylene black, carbon black, Ketjen black, a carbon dot, a carbon nanotube, graphene and carbon nanofiber.

Optionally, in one embodiment, the positive electrode material further optionally includes a binding agent. As an example, the binding agent may include at least one of polyvinylidene fluoride (PVDF), polytetrafluoroethylene (PTFE), a vinylidene fluoride-tetrafluoroethylene-propylene terpolymer, a vinylidene fluoride-hexafluoropropylene-tetrafluoroethylene terpolymer, a tetrafluoroethylene-hexafluoropropylene copolymer and fluorinated acrylate resin.

Optionally, in one embodiment, the positive electrode plate may be prepared by the following ways: disperse the components for preparing the positive electrode plate, for example, the positive electrode active material, the conductive agent, the binding agent and any other components, into the solvent (such as N-methylpyrrolidone) to form a positive electrode slurry; and coat the positive electrode current collector with the positive electrode slurry and then obtain the negative electrode plate through the processes of drying and cold pressing.

[Electrolyte]

The electrolyte plays a role in conducting ions between the positive electrode plate and the negative electrode plate. The type of the electrolyte may not be specifically limited by the present application, and may be selected according to requirements. For example, the electrolyte may be liquid, gel or all-solid.

Optionally, in one embodiment, the electrolyte adopts an electrolyte solution. The electrolyte solution includes an electrolyte salt and a solvent.

Optionally, in one embodiment, the electrolyte salt may be selected from at least one of lithium hexafluorophosphate, lithium tetrafluoroborate, lithium perchlorate, lithium hexafluoroarsenate, lithium difluorosulfonimide, lithium trifluoromethanesulfonate, lithium triflate, lithium difluorophosphate, lithium bis(oxalate)borate, lithium difluoroborate, lithium difluorodioxalate phosphate and lithium tetrafluorooxalate phosphate.

Optionally, in one embodiment, the solvent may be selected from at least one of ethylene carbonate, propyl carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1, 4-butyrolactone, sulfolane, dimethyl sulfone, methyl ethyl sulfone and diethyl sulfone.

Optionally, in one embodiment, the electrolyte solution further includes an additive. For example, the additive may include a negative electrode film-forming additive and a positive electrode film-forming additive, and may further include an additive capable of improving some performance of the battery, for example, an additive capable of improving the overcharge performance of the battery and an additive capable of improving the high-temperature or low-temperature performance of the battery.

[Separator]

Optionally, in one embodiment, the secondary battery further includes a separator. The type of the separator is not specially limited by the present application, for example, any well-known porous structure isolating film with high chemical stability and mechanical stability may be adopted.

Optionally, in one embodiment, a material of the isolating film may be selected from at least one of glass fiber, non-woven fabric, polyethylene, polypropylene and polyvinylidene fluoride. The isolating film may be a single-layer film, or may be a multi-layer composite film, which is not particularly limited herein. When the isolating film is the multi-layer composite film, and a material of each layer may be the same or different, which is not particularly limited herein.

Optionally, in one embodiment, the positive electrode plate, the negative electrode plate and the isolating film may be made into an electrode assembly through a winding process or a lamination process.

Optionally, in one embodiment, the secondary battery may include an outer package. The outer package may be configured to package the electrode assembly and the electrolyte.

Optionally, in one embodiment, the outer package of the secondary battery may be a hard shell, for example, a hard plastic shell, an aluminum shell and a steel shell. The outer package of the secondary battery may also be a soft package, for example, a bag-type soft package. A material of the soft package may be plastic, as plastic, for example, polypropylene, polybutylene terephthalate and polybutylene succinate.

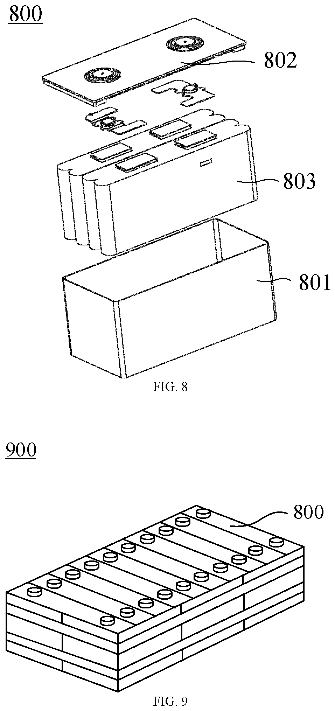

The shape of the secondary battery is not particularly limited by the present application, and may be a cylinder, a square or any other shapes. For example, FIG. 8 is a secondary battery 800 with a square structure as an example.

Optionally, in one embodiment, referring to FIG. 8, the outer package of the secondary battery 800 may include a shell 801 and a cover plate 802. The shell 801 may include a bottom plate and a side plate connected to the bottom plate. An accommodating cavity is surrounded by the bottom and the side plate. The shell 801 has an opening communicating with the accommodating cavity, and the cover plate 802 can cover the opening to close the accommodating cavity. The positive electrode plate, the negative electrode plate and the isolating film form an electrode assembly 803 through a winding process or a lamination process, and the electrode assembly 803 is packaged into the accommodating cavity and infiltrated into the electrode assembly 803. The number of the electrode assemblies 803 included in the secondary battery 800 may be one or more, which may be selected by those skilled in the art according to actual requirements.

Optionally, in one embodiment, the secondary battery 800 may be assembled into a battery module. The number of the secondary batteries 800 included in the battery module may be one or more. The specific number may be selected by those skilled in the art according to the application scenario and capacity of the battery module.

FIG. 9 is a schematic structural diagram of a battery module 900. Referring to FIG. 9, in the battery module 900, a plurality of secondary batteries 800 may be arranged sequentially in a length direction of the battery module 900, and of course, may be arranged according to any other manners. Further, the plurality of secondary batteries 800 may be fixed through a fastener.

Optionally, in one embodiment, the battery module 900 may further include an outer shell with an accommodating space, and the plurality of secondary batteries 800 are accommodated in the accommodating space.

Optionally, in one embodiment, the battery module 900 may be assembled into a battery pack. The number of the battery modules 900 included in the battery pack may be one or more. The specific number may be selected by those skilled in the art according to the application scenario and capacity of the battery pack.

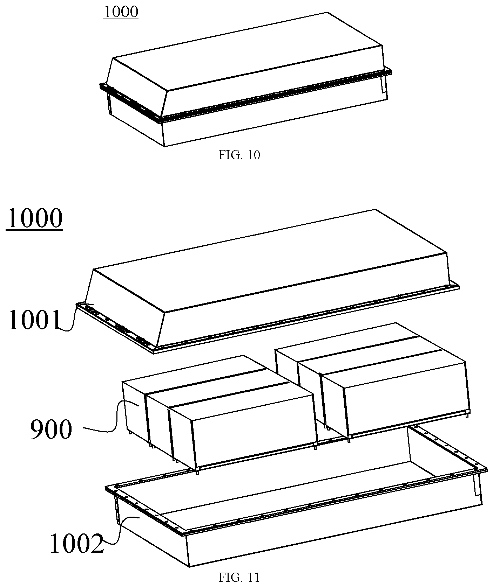

FIG. 10 and FIG. 11 are schematic diagrams of a battery pack 1000. Referring to FIG. 10 and FIG. 11, the battery pack 1000 may include a battery box and a plurality of battery modules 900 arranged in the battery box. The battery box includes an upper box body 1001 and a lower box body 1002. The upper box body 1001 can cover the lower box body 1002 and form a closed space for accommodating the battery modules 900. The plurality of battery modules 900 may be arranged in the battery box according to any manner.

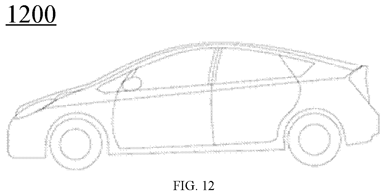

FIG. 12 is a schematic diagram of an electrical apparatus 1200 according to the present application.

It should be understood that the electrical apparatus 1200 includes at least one of the secondary battery 800 provided by the present application, the battery module 900 or the battery pack 1000. The secondary battery 800, the battery module 900 or the battery pack 1000 may serve as a power supply of the electrical apparatus 1200, or may serve as an energy storage unit of the electrical apparatus 1200. The electrical apparatus 1200 may include a mobile device (such as a mobile phone and a notebook computer), an electric vehicle (such as a pure electric vehicle, a hybrid electric vehicle, a plug-in hybrid electric vehicle, an electric bicycle, an electric scooter, an electric golf cart and an electric truck), an electrical train, a ship, a satellite and an energy storage system, but the electrical apparatus is not limited thereto.

As the electrical apparatus 1200, the secondary battery 800, the battery module 900 or the battery pack 1000 may be selected according to the use requirements of the electrical apparatus.

As an example of the electrical apparatus 1200, as shown in FIG. 12, the electrical apparatus 1200 is a pure electric vehicle, a hybrid electric vehicle or a plug-in hybrid electric vehicle. To meet the requirement of the electrical apparatus 1200 on high power and high energy density of the secondary battery 10, the battery pack 1000 or the battery module 900 may be adopted.

As another example, the electrical apparatus 1200 may be a mobile phone, a tablet personal computer and a notebook computer. The apparatus usually requires thinness, and may use the secondary battery 800 as the power supply.

In addition, the embodiments of the present application further provide application of a silicon-carbon compound in the embodiments of the present application to preparation of a secondary battery.

Embodiment

The embodiments of the present application are described below. The embodiments described below are exemplary, only used to explain the present application but cannot be construed as a limitation to the present application. In the cases where the techniques or conditions are not specified, the embodiments are implemented according to the techniques or conditions described in the literature in the art or according to the product manual. All of the used agents or instruments which are not specified with the manufacturer are conventional commercially-available products.

I Preparation of silicon-carbon compound

I-I Preparation of porous carbon matrix

Porous carbon matrix 1

Firstly, 50 g of resin with the solid content of 80% was weighed as a base material, 100 g of absolute ethanol was weighed as a solvent, the absolute ethanol was poured into the resin slowly and stirred for a period of time until a uniform alcohol solution was obtained. Secondly, 50 g of zinc chloride was weighed as a pore-forming agent, the alcohol solution was added, and the mixture was continuously stirred at a rotational speed of 1000 r/min for 3 hours to obtain a uniform and clear blended resin solution, that is, a first mixture. Thirdly, the first mixture was transferred into a heat-resistant mould and put into a blasting oven, and the first mixture was treated under the condition of T1=40°C, so that the first mixture was preliminarily solidified to obtain a second mixture. Fourthly, the second mixture was coarsely crushed, and the coarsely crushed second mixture was subjected to heat treatment for 10 hours under the conditions of T2=130 °C and oxygen to obtain a carbon precursor. Fifthly, the carbon precursor was further finely crushed, the finely crushed smaller particles were carbonized for 2 hours in a heating device under the conditions of T3=1000°C and nitrogen to obtain a carbonized product. Finally, the carbonized product was subjected to impurity removal, demagnetization and screening to obtain the porous carbon matrix 1. The porous carbon matrix 1 meets: $V_{total}$=0.068 cm$^3$, $S_{total}$=19.8 m$^2$, and $V_{total}/S_{total}$=3.43 nm.

Porous carbon matrix 2

Compared with the porous carbon matrix 1, the difference between the porous carbon matrix 2 and the porous carbon matrix 1 is that the use amount of the zinc chloride is 25 g, and T1=60°C

Porous carbon matrix 3

Compared with the porous carbon matrix 1, the difference between the porous carbon matrix 3 and the porous carbon matrix 1 is that the use amount of the zinc chloride is 16.67 g, and the use amount of the absolute ethanol is 200 g.

Porous carbon matrix 4

Compared with the porous carbon matrix 1, the difference between the porous carbon matrix 4 and the porous carbon matrix 1 is that the use amount of the zinc chloride is 10 g, the use amount of the absolute ethanol is 500 g, T1=60°C, and T2=150°C.

Porous carbon matrix 5

Compared with the porous carbon matrix 1, the difference between the porous carbon matrix 5 and the porous carbon matrix 1 is that the use amount of zinc chloride is 1.25 g, the use amount of absolute ethanol is 2000 g, T1=80°C, and T2=150°C.

Porous carbon matrix 6

Compared with the porous carbon matrix 1, the difference between the porous carbon matrix 6 and the porous carbon matrix 1 is that the use amount of the zinc chloride is 0.83 g, the use amount of the absolute ethanol is 3000 g, T1=80°C, T2=180°C, and T3=800°C.

Porous carbon matrix 7

Compared with the porous carbon matrix 1, the difference between the porous carbon matrix 7 and the porous carbon matrix 1 is that the use amount of the absolute ethanol is 5000 g, and T1=80°C

Porous carbon matrix 8

Compared with the porous carbon matrix 1, the difference between the porous carbon matrix 8 and the porous carbon matrix 1 is that the use amount of zinc chloride is 5000 g, the use amount of absolute ethanol is 5000 g, T1=80°C, T2=150°C, and T3=800 °C.

Porous carbon matrix 9

Compared with the porous carbon matrix 1, the difference between the porous carbon matrix 9 and the porous carbon matrix 1 is that the use amount of the absolute ethanol is 4000 g, T1=80°C, T2=180°C, and T3=800°C.

Carbon matrix 1

Compared with the porous carbon matrix 1, the difference between the carbon matrix 1 and the porous carbon matrix 1 is that T1=120°C, and T2=250°C.

Carbon matrix 2

Compared with the porous carbon matrix 1, the difference between the carbon matrix 2 and the porous carbon matrix 1 is that the use amount of the zinc chloride is 0.5 g, the use amount of the absolute ethanol is 4000 g, T1=120°C, T2=250°C, and the second mixture is heated under the nitrogen atmosphere.

The heating device includes but is not limited to an atmosphere box furnace, a tube furnace, a rotary furnace and a pushed slab kiln.

I-II Preparation of silicon-carbon compound

Silicon-carbon compound 1

The prepared porous carbon matrix 1 was placed in the heating device, and was heated to 500°C under the positive pressure of 200 Pa-500 Pa and at a heating speed of 1°C/min by controlling the flow of a silane gas to 5 L/min in the atmosphere of the silane gas with the volume fraction of 20% and hydrogen with the volume fraction of 80%, and nano-silicon particles were deposited on the porous carbon matrix to obtain a silicon-carbon compound 1. In the silicon-carbon compound 1, Dv50=8.2$\mu$m, Dv90=15.8$\mu$m, (Dv90-Dv10)/Dv50=1.68, SSA=2.8 m$^2$/g, and the size of the silicon-based particles is: d=2 nm.

Silicon-carbon compound 2

Compared with the silicon-carbon compound 1, the silicon-carbon compound 2 is prepared from the porous carbon matrix 2 through the above processes.

Silicon-carbon compound 3

Compared with the silicon-carbon compound 1, the silicon-carbon compound 3 is prepared from the porous carbon matrix 3 through the above processes, where the heating speed in the heating process is 2°C/min

Silicon-carbon compound 3

Compared with the silicon-carbon compound 1, the silicon-carbon compound 3 is prepared from the porous carbon matrix 3 through the above processes, where the heating speed in the heating process is 2°C/min.

Silicon-carbon compound 4

Compared with the silicon-carbon compound 1, the silicon-carbon compound 4 is prepared from the porous carbon matrix 4 through the above processes, where the heating speed in the heating process is 2°C/min, and heating is performed until 600°C.

Silicon-carbon compound 5

Compared with the silicon-carbon compound 1, the silicon-carbon compound 4 is prepared from the porous carbon matrix 5 through the above processes, where the heating speed in the heating process is 5°C/min, and heating is performed until 600°C.

Silicon-carbon compound 6

Compared with the silicon-carbon compound 1, the silicon-carbon compound 6 is prepared from the porous carbon matrix 6 through the above processes, where the heating speed in the heating process is 5°C/min, and heating is performed until 600°C.

Silicon-carbon compound 7

Compared with the silicon-carbon compound 1, the silicon-carbon compound 7 is prepared from the porous carbon matrix 7 through the above processes, where the heating speed in the heating process is 5°C/min, and heating is performed until 600°C.

Silicon-carbon compound 8

Compared with the silicon-carbon compound 1, the silicon-carbon compound 8 is prepared from the porous carbon matrix 8 through the above processes, where the heating speed in the heating process is 5°C/min, and heating is performed until 600°C.

Silicon-carbon compound 9

Compared with the silicon-carbon compound 1, the silicon-carbon compound 9 is prepared from the porous carbon matrix 9 through the above processes, where the heating speed in the heating process is 5°C/min, and heating is performed until 600°C.

Silicon-carbon compound 10

Compared with the silicon-carbon compound 1, the silicon-carbon compound 10 is prepared from the carbon matrix 1 through the above processes, where the heating speed in the heating process is 10°C/min, and heating is performed until 600°C.

Silicon-carbon compound 11

Compared with the silicon-carbon compound 1, the silicon-carbon compound 11 is prepared from the carbon matrix 2 through the above processes, where the heating speed in the heating process is 10°C/min, and heating is performed until 600°C.

II Preparation of secondary battery

II-I Preparation of positive electrode plate

A positive electrode active material lithium iron phosphate, a conductive agent acetylene black and a binding agent polyvinlylidene fluoride (PVDF) were dissolved into a solvent N-methylpyrrolidone (NMP) according to a mass ratio of 90:5:5, and were stirred and mixed completely and uniformly to obtain a positive electrode slurry. Then a positive electrode current collector aluminum foil was uniformly coated with the positive electrode slurry, and drying, cold pressing and slitting were performed to obtain the positive electrode plate.

II-II Preparation of negative electrode plate

A negative electrode active material silicon-carbon composite material, a conductive agent acetylene black, a binding agent butadiene styrene rubber (SBR) and a thickening agent carboxyl methyl cellulose (CMC) were dissolved into a solvent deionized water according to a mass ratio of 90:4:4:2 and were mixed uniformly to obtain a negative electrode slurry. A negative electrode current collector copper foil was uniformly coated with the negative electrode slurry for one or more times, and drying, cold pressing and slitting were performed to obtain the negative electrode plate.
The electrode plate prepared from the silicon-carbon composite material 1-11 respectively corresponds to the negative electrode plate 1-11.

II-III Preparation of electrolyte solution

In the argon environment, organic solvents EC and DMC were mixed uniformly according to a volume ratio of 1:1, 1 M of LiPF$_6$ was added and dissolved into the organic solvents, fluoroethylene carbonate (FEC) with the volume fraction of 10% was added as an additive, and the above materials were mixed uniformly to obtain the electrolyte solution.

II-III Assembling of secondary battery

The positive electrode plate, the isolating film and the negative electrode plate were stacked sequentially, so that the isolating film is located between the positive electrode plate and the negative electrode plate and can isolate the positive electrode plate and the negative electrode plate; then, the stacked components were wound to obtain an electrode assembly; the electrode assembly is arranged in a battery shell and is dried, and then the electrolyte solution is injected; and secondary batteries in different embodiments and comparative examples were obtained through the processes of formation and standing.
Embodiment 1: the secondary battery obtained by assembling the positive electrode plate, the isolating film, the negative electrode plate 1 and the electrolyte solution by the above method is Embodiment 1.
Embodiment 2: the secondary battery obtained by assembling the positive electrode plate, the isolating film, the negative electrode plate 2 and the electrolyte solution by the above method is Embodiment 2.
Embodiment 3: the secondary battery obtained by assembling the positive electrode plate, the isolating film, the negative electrode plate 3 and the electrolyte solution by the above method is Embodiment 3.
Embodiment 4: the secondary battery obtained by assembling the positive electrode plate, the isolating film, the negative electrode plate 4 and the electrolyte solution by the above method is Embodiment 4.
Embodiment 5: the secondary battery obtained by assembling the positive electrode plate, the isolating film, the negative electrode plate 5 and the electrolyte solution by the above method is Embodiment 5.
Embodiment 6: the secondary battery obtained by assembling the positive electrode plate, the isolating film, the negative electrode plate 6 and the electrolyte solution by the above method is Embodiment 6.
Embodiment 7: the secondary battery obtained by assembling the positive electrode plate, the isolating film, the negative electrode plate 7 and the electrolyte solution by the above method is Embodiment 7.
Embodiment 8: the secondary battery obtained by assembling the positive electrode plate, the isolating film, the negative electrode plate 8 and the electrolyte solution by the above method is Embodiment 8.
Embodiment 9: the secondary battery obtained by assembling the positive electrode plate, the isolating film, the negative electrode plate 9 and the electrolyte solution by the above method is Embodiment 9.

Comparative Example 1: the secondary battery obtained by assembling the positive electrode plate, the isolating film, the negative electrode plate 10 and the electrolyte solution by the above method is Comparative Example 1.

Comparative Example 2: the secondary battery obtained by assembling the positive electrode plate, the isolating film, the negative electrode plate 11 and the electrolyte solution by the above method is Comparative Example 2.

The parameters of products of different embodiments are shown in Table 1 for details.

Table 1: product parameters of comparative examples and embodiments

| Serial Number | m (Base Material): m (Pore-forming Agent) | m (Base Material): m (Solvent) | T1 (°C) | T2 (°C) | T3 (°C) | Solidification Treatment Atmosphere | Heating Speed from Room Temperature to Constant Temperature | Constant Temperature (°C) |
|---|---|---|---|---|---|---|---|---|
| Embodiment 1 | 1:1 | 1:2 | 40 | 130 | 1000 | Oxygen | 1 °C/min | 500 |
| Embodiment 2 | 2:1 | 1:2 | 60 | 130 | 1000 | Oxygen | 1 °C/min | 500 |
| Embodiment 3 | 3:1 | 1:4 | 40 | 130 | 1000 | Oxygen | 2 °C/min | 500 |
| Embodiment 4 | 5:1 | 1:10 | 60 | 150 | 1000 | Oxygen | 2 °C/min | 600 |
| Embodiment 5 | 40:1 | 1:40 | 80 | 150 | 1000 | Oxygen | 5 °C/min | 600 |
| Embodiment 6 | 60:1 | 1:60 | 80 | 180 | 800 | Oxygen | 5 °C/min | 600 |
| Embodiment 7 | 1:1 | 1:100 | 80 | 130 | 1000 | Oxygen | 5 °C/min | 600 |
| Embodiment 8 | 100:1 | 1:100 | 80 | 150 | 800 | Oxygen | 5 °C/min | 600 |
| Embodiment 9 | 1:1 | 1:80 | 80 | 150 | 800 | Oxygen | 5 °C/min | 600 |
| Comparative Example 1 | 1:1 | 1:2 | 120 | 250 | 1000 | Oxygen | 10 °C/min | 500 |
| Comparative Example 2 | 100:1 | 1:80 | 120 | 250 | 1000 | Nitrogen | 10 °C/min | 500 |

Then, the test process of the related parameters and battery performance are described.

III Parameter and battery performance test

III-I Powder resistivity test

A certain mass of silicon-carbon composite material was weighed, the depth of a loading chamber was adjusted, a sample was added into the loading chamber, a pressure was applied, data was acquired manually, and the test results of the powder resistivities at different pressure points were recorded.

III-II DCR test

At 25°C, the secondary battery was charged to 4.3 V at a constant current of 0.33 C, then was charged at a constant pressure of 4.3 V until the current is less than 0.05 C, and then was discharged to 2 V at a current of 0.33 C, and the actual capacity $C_0$ of a battery cell was tested. Then, the secondary battery was charged to 3.65 C at a constant current of 0.33 C, was charged at a constant voltage of 3.65 V until the current is less than 0.05 C and then was discharged for 30 minutes at a current of 1C0, that is, after the electric quantity of the battery cell was adjusted to 50%SOC, positive and negative pens of a TH2523A alternating-current internal resistance test instrument were respectively touched with the positive and negative electrodes of the battery, and a DCR value at 25°C-50% SOC was obtained by the internal resistance test instrument.

The prepared comparative examples and embodiments were respectively subjected to battery performance test by the above method, and the test results were shown in Table 2 for details.

Table 2: test results of the battery performance of the comparative examples and the embodiments

| Serial Number | $V_{total}$ (cm$^3$) | $S_{total}$ ($\times 10^4$ cm$^2$/g) | $V_{total}/S_{total}$ | 4Mpa Powder Resistivity | DCR Value of Battery (m$\Omega$) | Capacity Retention Rate (%) After 500 Cycles at 25°C |
|---|---|---|---|---|---|---|
| Embodiment 1 | 0.092 | 45 | $2.0\times10^{-7}$ | 1.5 | 510 | 91 |
| Embodiment 2 | 0.077 | 35 | $2.2\times10^{-7}$ | 1.6 | 550 | 90 |
| Embodiment 3 | 0.074 | 25 | $3.0\times10^{-7}$ | 10.8 | 628 | 87 |
| Embodiment 4 | 0.072 | 18 | $4.0\times10^{-7}$ | 50.5 | 791 | 85 |
| Embodiment 5 | 0.110 | 20 | $5.5\times10^{-7}$ | 72.3 | 858 | 84 |
| Embodiment 6 | 0.160 | 23 | $7.0\times10^{-7}$ | 95.7 | 884 | 82 |
| Embodiment 7 | 0.200 | 25 | $8.0\times10^{-7}$ | 120.5 | 892 | 80 |
| Embodiment 8 | 0.004 | 4 | $1.0\times10^{-7}$ | 1.40 | 780 | 84 |
| Embodiment 9 | 0.250 | 25 | $10\times10^{-7}$ | 125.8 | 950 | 78 |
| Comparative Example 1 | 0.240 | 20 | $12.0\times10^{-7}$ | 310 | 1000 | 70 |
| Comparative Example 2 | 0.080 | 10 | $0.8\times10^{-7}$ | 380 | 1200 | 68 |

It can be seen from Table 1 and Table 2 that in Embodiments 1-9, the material can meet that $V_{total}/S_{total}$ is within in a specific range by adjusting the preparation parameters for preparing the porous carbon matrix, so that the composite material has high electrical conductivity and structural stability, the energy density of the battery can be improved, and the secondary battery has high cycle performance and low DCR. In the materials of Comparative Example 1-2, $V_{total}/S_{total}$ is not within the range of the present application, so that the cycle performance and DCR of the battery are relatively poor.

It should be noted that the present invention is not limited to the above embodiments. The above embodiments are only examples, and the embodiments having the same structure as the technical idea and exerting the same effect within the scope of the technical solution are all included in the technical scope of the present application. In addition, various modifications that can be thought of by those skilled in the art are applied to the embodiments without departing from the scope of the present application, and other manners formed by combining some constituting elements in the embodiments are also included in the scope of the present application.

**Claims**

1. A silicon-carbon composite material, comprising:

   a porous carbon matrix and silicon-based particles,
   wherein the porous carbon matrix internally comprises a plurality of pore channels with a width of 5 nm-50 nm; the silicon-based particles are distributed in the pore channels; and the porous carbon matrix meets: $1.0\times10^{-7}\leq V_{total}/S_{total}\leq10.0\times10^{-7}$,
   $S_{total}$ being the total surface area occupied by the pore channels with the width of 5 nm-50 nm, and the measurement unit being: $\times10^4$ cm$^2$/g, and
   $V_{total}$ being the total pore volume occupied by the pore channels with the width of 5 nm-50 nm, and the measurement unit being: cm$^3$/g.

2. The silicon-carbon composite material according to claim 1, wherein $1.5\times10^{-7}\leq V_{total}/S_{total}\leq80\times10^{-7}$, optionally, $2.0\times10^{-7}\leq V_{total}/S_{total}\leq5.0\times10^{-7}$.

3. The silicon-carbon composite material according to claim 1, wherein $1 \leq S_{total} \leq 50$, optionally, $1 \leq S_{total} \leq 30$, and the measurement unit is: $\times 10^4$ cm$^2$/g.

4. The silicon-carbon composite material according to claim 1, wherein $0.002 \leq V_{total} \leq 0.250$, optionally, $0.004 \leq V_{total} \leq 0.200$, and the measurement unit is: cm$^3$/g.

5. The silicon-carbon composite material according to any one of claims 1-4, wherein the powder resistivity of the porous carbon matrix under the pressure of 4 MPa is 1 $\Omega$/cm-300 $\Omega$/cm, optionally, 1 $\Omega$/cm-100 $\Omega$/cm.

6. The silicon-carbon composite material according to any one of claims 1-5, wherein

   the volume particle size distribution of the porous carbon matrix is: $Dv_{50} \leq 10$ $\mu$m, optionally, 5 $\mu$m $\leq Dv_{50} \leq 10$ $\mu$m; and/or
   the volume particle size distribution of the porous carbon matrix is: $Dv_{90} \leq 20$ $\mu$m, optionally, 10 $\mu$m $\leq Dv_{90} \leq 15$ $\mu$m.

7. The silicon-carbon composite material according to any one of claims 1-6, wherein the size of the silicon-based particles is less than or equal to 20 nm, optionally, 2 nm-10 nm.

8. The silicon-carbon composite material according to any one of claims 1-7, wherein the content of the silicon-based particles in the silicon-carbon composite material is 25%-65%, optionally, 35%-45%.

9. The silicon-carbon composite material according to any one of claims 1-8, wherein

   the powder resistivity R of the silicon-carbon composite material under the pressure of 12 MPa is less than or equal to 300 $\Omega$/cm, optionally, 1 $\Omega$/cm-200 $\Omega$/cm; and/or
   the powder resistivity R of the silicon-carbon composite material under the pressure of 16 MPa is less than or equal to 200 $\Omega$/cm, optionally, 1 $\Omega$/cm-100 $\Omega$/cm.

10. The silicon-carbon composite material according to any one of claims 1-9, wherein the silicon-carbon composite material
    meets one or more of the following (1) to (6):

    (1) the volume particle size distribution of the silicon-carbon composite material is $Dv_{10} \leq 5\mu$m, optionally, $3 \leq Dv_{10} \leq 5$ $\mu$m;
    (2) the volume particle size distribution of the silicon-carbon composite material is $Dv_{50} \leq 10$ $\mu$m, optionally, $5 \leq Dv_{10} \leq 10$ $\mu$m;
    (3) the volume particle size distribution of the silicon-carbon composite material is $Dv_{90} \leq 20$ $\mu$m, optionally, $10 \leq Dv_{10} \leq 15$ $\mu$m;
    (4) the volume particle size distribution of the silicon-carbon composite material is $(D_{v90}-D_{v10})/D_{v50} \leq 1.8$, optionally, $1.5 \leq (D_{v90}-D_{v10})/D_{v50} \leq 1.7$;
    (5) the compaction density of the silicon-carbon composite material under the pressure of 2 MPa is 1 g/cm$^3$-1.5 g/cm$^3$, optionally, 1.1 g/cm$^3$-1.3 g/cm$^3$; and
    (6) the specific surface area (SSA) of the silicon-carbon composite material is 2 m$^2$/g-10 m$^2$/g, optionally, 3 m$^2$/g-7 m$^2$/g.

11. The silicon-carbon composite material according to any one of claims 1-10, wherein the peak value of an X-ray diffraction (XRD) peak of the silicon-carbon composite material between the diffraction angle 28° and 29° is denoted as P1, and the peak value of an XRD peak of the silicon-based particles between the diffraction angle 42° and 45° is denoted as P2, then $2 \leq P1/P2 \leq 4$, optionally, $600 \leq P1 \leq 800$, and optionally, $200 \leq P2 \leq 400$.

12. A preparation method of a silicon-carbon composite material, comprising:

    mixing a base material and a pore-forming agent in a solvent to obtain a first mixture;
    treating the first mixture at a high temperature to obtain a porous carbon matrix; and
    depositing a silane gas in the porous carbon matrix through chemical vapor deposition to obtain the silicon-carbon composite material.

13. The preparation method according to claim 12, wherein the base material comprises at least one of sugar and resin;

optionally, the sugar comprises at least one of glucose, sucrose, fructose, starch, amylopectin, amylose, lignin, dextrin and maltodextrin; and

optionally, the resin comprises at least one of linear phenolic resin, soluble phenolic resin, epoxy resin and polyurethane.

14. The preparation method according to claim 12 or 13, wherein the pore-forming agent comprises at least one of sodium chloride, potassium chloride, zinc chloride, sodium carbonate and potassium carbonate.

15. The preparation method according to any one of claims 12-14, wherein a mass ratio of the base material to the pore-forming agent is 1:5-10:1, optionally, 2:1-5:1.

16. The preparation method according to any one of claims 12-15, wherein the solvent comprises water or alcohol, the alcohol comprising at least one of methanol, ethanol, ethylene glycol, polyethylene glycol, glycerol, isopropanol or polyalcohol.

17. The preparation method according to any one of claims 12-16, wherein a mass ratio of the base material to the solvent is 1:100-10:1, optionally, 1:2-10:1.

18. The preparation method according to any one of claims 12-17, wherein the mixing a base material and a pore-forming agent in a solvent comprises: mixing the base material and the pore-forming agent in the solvent through stirring, optionally, the stirring speed being 100 rpm/min-1500 rpm/min, further optionally, 200 rpm/min-1000 rpm/min.

19. The preparation method according to any one of claims 12-18, wherein the treating the first mixture at a high temperature to obtain a porous carbon matrix comprises:

    treating the first mixture at a first temperature to obtain a second mixture, the second mixture being a solid mixture;
    treating the second mixture at a second temperature to obtain a carbon precursor; and
    treating the carbon precursor at a third temperature to obtain the porous carbon matrix.

20. The preparation method according to claim 19, wherein the first temperature, the second temperature and the third temperature meet one or more of the following (I) to (III):

    (I) the first temperature is 40 °C-80 °C, optionally, 40 °C-60 °C;
    (II) the second temperature is 100 °C-200 °C, optionally, 130 °C-180 °C; and
    (III) the third temperature is 600 °C-1200 °C, optionally, 800 °C-1000 °C.

21. The preparation method according to any one of claims 19-20, comprising: crushing the second mixture before treating the second mixture at the second temperature.

22. The preparation method according to any one of claims 19-21, further comprising: crushing the carbon precursor before treating the carbon precursor at the third temperature,
wherein optionally, after the carbon precursor is crushed, the particle size of the carbon precursor is 1 $\mu$m-1000 $\mu$m, further optionally, 5 $\mu$m-100 $\mu$m.

23. The preparation method according to any one of claims 19-22, wherein the treating the carbon precursor at a third temperature comprises: treating the carbon precursor in an inert gas at the third temperature,
optionally, the inert gas comprising at least one of nitrogen, argon and helium.

24. The preparation method according to any one of claims 12-23, further comprising: performing impurity removal and/or demagnetization on the porous carbon matrix before depositing the silicon-based particles in the porous carbon matrix.

25. The preparation method according to any one of claims 12-24, wherein the atmosphere of the chemical vapor deposition is a mixed gas of a silane gas and hydrogen,
optionally, the volume of the silane gas accounting for 10%-50% of the volume of the mixed gas.

26. The preparation method according to any one of claims 12-25,

wherein the flow of depositing the silane gas through the chemical vapor deposition is 0.5 L/min-1 L/min; and/or the temperature of the chemical vapor deposition is 500 °C-800 °C.

27. A secondary battery, comprising a negative electrode plate, wherein the negative electrode plate comprises the silicon-carbon composite material according to any one of claims 1-11, or comprises the silicon-carbon composite material prepared by the method according to any one of claims 12-26.

28. An electrical apparatus, comprising the secondary battery according to claim 27.

FIG. 1

FIG. 2

FIG. 3

FIG. 4

## Embodiment 1

FIG. 5

600

| Mix a base material and a pore-forming agent in a solvent to obtain a first mixture | S601 |

| Treat the first mixture at a high temperature to obtain a porous carbon matrix | S602 |

| Deposit a silane gas in the porous carbon matrix through chemical vapor deposition to obtain the silicon-carbon composite material | S603 |

FIG. 6

600

| Mix a base material and a pore-forming agent in a solvent to obtain a first mixture | S601 |

| Treat the first mixture at a first temperature T1 to obtain a second mixture, where the second mixture is a solid mixture | S6021 |

| Treat the second mixture at a second temperature T2 to obtain a carbon precursor | S6022 |

| Treat the carbon precursor at a third temperature T3 to obtain the porous carbon matrix | S6022 |

| Deposit a silane gas in the porous carbon matrix through chemical vapor deposition to obtain the silicon-carbon composite material | S603 |

FIG. 7

<u>800</u>

802

803

801

FIG. 8

<u>900</u>

800

FIG. 9

FIG. 10

FIG. 11

1200

FIG. 12

## INTERNATIONAL SEARCH REPORT

| International application No. |
| --- |
| **PCT/CN2022/115303** |

| A. | CLASSIFICATION OF SUBJECT MATTER |
| --- | --- |
| | H01M 4/134(2010.01)i;  H01M 4/133(2010.01)i |

According to International Patent Classification (IPC) or to both national classification and IPC

| B. | FIELDS SEARCHED |
| --- | --- |

Minimum documentation searched (classification system followed by classification symbols)

    H01M

Documentation searched other than minimum documentation to the extent that such documents are included in the fields searched

Electronic data base consulted during the international search (name of data base and, where practicable, search terms used)

    CNPAT, WPI, EPODOC, CNKI: 电池, 负极, 硅, 碳, 炭, 复合, 多孔, 纳米, 孔体积, 面积, 沉积, battery, anode, silicon, carbon, composite, porous, pore, volume, surface, deposit+

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 103840140 A (TSINGHUA UNIVERSITY et al.) 04 June 2014 (2014-06-04) description, paragraphs 6-65, and figures 1a-1c | 12-28 |
| X | CN 114287072 A (NEXEON LIMITED) 05 April 2022 (2022-04-05) description, paragraphs 9-131 | 12-28 |
| X | CN 108475779 A (ENERG2 TECHNOLOGIES, INC. et al.) 31 August 2018 (2018-08-31) description, paragraphs 18-46 | 12-28 |
| X | CN 114044516 A (HUIZHOU LIWINON NEW ENERGY TECHNOLOGY CO., LTD.) 15 February 2022 (2022-02-15) description, paragraphs 5-50 | 12-28 |
| A | US 2022166013 A1 (SK INNOVATION CO., LTD. et al.) 26 May 2022 (2022-05-26) entire document | 1-28 |

| ☐ Further documents are listed in the continuation of Box C. | ☑ See patent family annex. |
| --- | --- |

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **08 December 2022** | **29 December 2022** |

| Name and mailing address of the ISA/CN | Authorized officer |
| --- | --- |
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/115303**

| Patent document cited in search report | | | Publication date (day/month/year) | Patent family member(s) | | | Publication date (day/month/year) |
|---|---|---|---|---|---|---|---|
| CN | 103840140 | A | 04 June 2014 | None | | | |
| CN | 114287072 | A | 05 April 2022 | WO | 2021048556 | A1 | 18 March 2021 |
| | | | | EP | 4028356 | A1 | 20 July 2022 |
| | | | | US | 2022336791 | A1 | 20 October 2022 |
| | | | | KR | 20220061976 | A | 13 May 2022 |
| | | | | JP | 2022547660 | A | 15 November 2022 |
| | | | | GB | 201913073 | D0 | 23 October 2019 |
| CN | 108475779 | A | 31 August 2018 | US | 2022352517 | A1 | 03 November 2022 |
| | | | | KR | 20180113187 | A | 15 October 2018 |
| | | | | EP | 3341990 | A1 | 04 July 2018 |
| | | | | EP | 3836261 | A1 | 16 June 2021 |
| | | | | US | 2022231296 | A1 | 21 July 2022 |
| | | | | US | 2020152983 | A1 | 14 May 2020 |
| | | | | US | 2017170477 | A1 | 15 June 2017 |
| | | | | US | 2020075954 | A1 | 05 March 2020 |
| | | | | CN | 113224274 | A | 06 August 2021 |
| | | | | US | 2020365896 | A1 | 19 November 2020 |
| | | | | WO | 2017040299 | A1 | 09 March 2017 |
| | | | | JP | 2018534720 | A | 22 November 2018 |
| | | | | US | 2019280298 | A1 | 12 September 2019 |
| | | | | JP | 2022153561 | A | 12 October 2022 |
| CN | 114044516 | A | 15 February 2022 | None | | | |
| US | 2022166013 | A1 | 26 May 2022 | DE | 102021130755 | A1 | 02 June 2022 |
| | | | | KR | 20220073074 | A | 03 June 2022 |
| | | | | CN | 114551822 | A | 27 May 2022 |